# EUROPEAN PATENT APPLICATION

(11) **EP 4 507 003 A1**
(43) Date of publication of application: **12.02.2025**
(21) Application number: 24164202.4
(22) Date of filing: 18.03.2024
(51) Int. Cl.: H01L 29/06, H01L 29/08, H01L 29/423, H01L 29/51, H01L 21/336, H01L 29/775, H01L 29/78, H01L 29/66, H01L 29/165, H01L 29/417, B82Y 10/00

(54) **SEMICONDUCTOR DEVICE**

(30) Priority: 11.08.2023 KR 20230105286
(71) Applicant: Samsung Electronics Co., Ltd., Suwon-si, Gyeonggi-do 16677 (KR)
(72) Inventor: JEONG, Soojin, 16677 Suwon-si, Gyeonggi-do (KR); KANG, Myung Gil, 16677 Suwon-si, Gyeonggi-do (KR); KIM, Dongwon, 16677 Suwon-si, Gyeonggi-do (KR); PARK, Beomjin, 16677 Suwon-si, Gyeonggi-do (KR); SHIN, Dongsuk, 16677 Suwon-si, Gyeonggi-do (KR); YU, Hyun-Kwan, 16677 Suwon-si, Gyeonggi-do (KR); CHOI, Woosuk, 16677 Suwon-si, Gyeonggi-do (KR); HONG, Seungpyo, 16677 Suwon-si, Gyeonggi-do (KR)
(74) Representative: Kuhnen & Wacker Patent- und Rechtsanwaltsbüro PartG mbB

(57) **Abstract**

A semiconductor device includes a substrate including an active pattern, a channel pattern on the active pattern, the channel pattern including a plurality of semiconductor patterns that are spaced apart from each other, a source/drain pattern electrically connected to the plurality of semiconductor patterns, an inner gate electrode between adjacent first and second semiconductor patterns of the plurality of semiconductor patterns, an inner gate insulating layer between the inner gate electrode and the first and second semiconductor patterns, an inner high-k dielectric layer between the inner gate electrode and the inner gate insulating layer, and an inner spacer between the inner gate insulating layer and the source/drain pattern. As the inner gate insulating layer includes an inner gate spacer, the inner gate electrode may stably fill the inner gate space. As a result, the electrical characteristics of the semiconductor device may be improved.

## Description

### CROSS-REFERENCE TO RELATED APPLICATIONS

This U.S. non-provisional patent application claims priority under 35 U.S.C. §119 to Korean Patent Application No. 10-2023-0105286, filed on August 11, 2023, in the Korean Intellectual Property Office, the entire contents of which are hereby incorporated by reference.

### BACKGROUND

The present disclosure relates to a semiconductor device, and more particularly, to a semiconductor device including a field effect transistor and a method of manufacturing the same.

Semiconductor devices may include integrated circuits including metal-oxide-semiconductor field effect transistors (MOSFETs). As sizes and design rules of semiconductor devices have been reduced, MOSFETs have been scaled down. Operating characteristics of semiconductor devices may be deteriorated by reduction in size of MOSFETs. Accordingly, various methods for forming semiconductor devices which have excellent performance while overcoming limitations caused by high integration have been studied.

### SUMMARY

Embodiments of the inventive concepts may provide a semiconductor device with improved reliability and electrical characteristics.

In some embodiments, a semiconductor device may include a substrate including an active pattern, a channel pattern on the active pattern, the channel pattern including a plurality of semiconductor patterns that are spaced apart from each other, a source/drain pattern electrically connected to the plurality of semiconductor patterns, an inner gate electrode between adjacent first and second semiconductor patterns of the plurality of semiconductor patterns, an inner gate insulating layer between the inner gate electrode and the first and second semiconductor patterns, an inner high-k dielectric layer between the inner gate electrode and the inner gate insulating layer, and an inner spacer between the inner gate insulating layer and the source/drain pattern. The inner gate insulating layer may include an upper insulating layer between the inner gate electrode and the second semiconductor pattern, a lower insulating layer between the inner gate electrode and the first semiconductor pattern, and an inner gate spacer between the inner gate electrode and the source/drain pattern. A first thickness of the inner gate spacer at a center portion of the inner gate spacer may be greater than a second thickness of the upper insulating layer or the lower insulating layer, and a third thickness of the inner spacer may be greater than the first thickness of the inner gate spacer.

In some embodiments, a semiconductor device may include a substrate including a first active pattern and a second active pattern, a first channel pattern and a second channel pattern on the first active pattern and the second active pattern, respectively, the first and second channel patterns each includes a plurality of semiconductor patterns that are spaced apart from each other, a first source/drain pattern electrically connected to the first channel pattern, a second source/drain pattern electrically connected to the second channel pattern, a first inner gate electrode between adjacent semiconductor patterns of the plurality of semiconductor patterns of the first channel pattern, a second inner gate electrode between adjacent semiconductor patterns of the plurality of semiconductor patterns of the second channel pattern, a first inner gate insulating layer between the first inner gate electrode and the adjacent semiconductor patterns of the first channel pattern, a second inner gate insulating layer between the second inner gate electrode and the adjacent semiconductor patterns of the second channel pattern, a first inner high-k dielectric layer between the first inner gate electrode and the first inner gate insulating layer, and a second inner high-k dielectric layer between the second inner gate electrode and the second inner gate insulating layer. The first inner gate insulating layer may include a first upper insulating layer on a top surface of the first inner gate electrode, a first lower insulating layer on a top bottom of the first inner gate electrode, and a first inner gate spacer on both sidewalls of the first inner gate electrode. The second inner gate insulating layer may include a second upper insulating layer on a top surface of the second inner gate electrode, a second lower insulating layer on a bottom surface of the second inner gate electrode, and a second inner gate spacer on both sidewalls of the second inner gate electrode. The semiconductor device may further include an inner spacer between the first inner gate spacer and the first source/drain pattern. A thickness of the second inner gate spacer may be less than a sum of a thickness of the first inner gate spacer and a thickness of the inner spacer.

In some embodiments, a semiconductor device may include a substrate including an active pattern, a channel pattern on the active pattern, the channel pattern including a plurality of semiconductor patterns that are spaced apart from each other, a source/drain pattern electrically connected to the plurality of semiconductor patterns, a gate electrode on the plurality of semiconductor patterns, the gate electrode including an inner gate electrode between adjacent ones of the plurality of semiconductor patterns and an outer gate electrode on an uppermost semiconductor pattern of the plurality of semiconductor patterns, a gate insulating layer between the gate electrode and the plurality of semiconductor patterns, the gate insulating layer including an inner gate insulating layer between the inner gate electrode and the plurality of semiconductor patterns and an outer gate insulating layer on the uppermost semiconductor pattern, a high-k dielectric layer between the gate electrode and the gate insulating layer, and an inner spacer between the inner gate insulating layer and the source/drain pattern. The inner gate insulating layer may include an upper insulating layer on a top surface of the inner gate electrode, a lower insulating layer on a bottom surface of the inner gate electrode, and an inner gate spacer between the inner gate electrode and the inner spacer. Each of the upper insulating layer and the lower insulating layer may include body portions parallel to a top surface or bottom surface of the inner gate electrode, and tail portions on sides of the body portions. The body portion may have a first length in a vertical direction that is perpendicular to the substrate, and the tail portion may have a second length in the vertical direction. A variation of the second length according to a predetermined horizontal distance may be greater than a variation of the first length according to the predetermined horizontal distance.

### BRIEF DESCRIPTION OF THE DRAWINGS

FIGS. 1 to 3 are conceptual views illustrating logic cells of a semiconductor device according to some embodiments of the inventive concepts.
FIG. 4 is a plan view illustrating a semiconductor device according to some embodiments of the inventive concepts.
FIGS. 5A, 5B, 5C and 5D are cross-sectional views taken along lines A-A', B-B', C-C' and D-D' of FIG. 4, respectively.
FIG. 6A is an enlarged view illustrating an embodiment of a region 'M' of FIG. 5A.
FIG. 6B is an enlarged view illustrating an embodiment of a region 'N' of FIG. 5B.
FIG. 6C is an enlarged view illustrating an embodiment of a region 'P' of FIG. 6A.
FIG. 6D is an enlarged view illustrating an embodiment of the region 'M' of FIG. 5A.
FIG. 7 is an enlarged view illustrating an embodiment of the region 'M' of FIG. 5A.
FIGS. 8A, 8B, 9A, 9B, 10A, 10B, 10C, 10D, 11A, 11B, 11C, 12A, 12B, 12C, 12D, 13A, 13B, 13C, and 13D are cross-sectional views illustrating a method of manufacturing a semiconductor device according to some embodiments of the inventive concepts.
FIGS. 14 to 16 are enlarged views illustrating a method of forming a region 'M' of FIG. 10A.
FIGS. 17 to 19 are enlarged views illustrating a method of forming a region 'M' of FIG. 12A.

### DETAILED DESCRIPTION

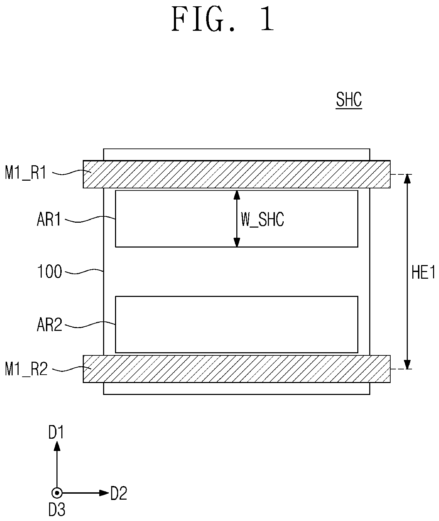

FIGS. 1 to 3 are conceptual views illustrating logic cells of a semiconductor device according to some embodiments of the inventive concepts.

Referring to FIG. 1, a single height cell SHC may be provided. More particularly, a first power interconnection line M1_R1 and a second power interconnection line M1_R2 may be provided on a substrate 100. The first power interconnection line M1_R1 may be a path through which a source voltage (VSS, e.g., a ground voltage) is provided. The second power interconnection line M1_R2 may be a path through which a drain voltage (VDD, e.g., a power voltage) is provided.

The single height cell SHC may be defined between the first power interconnection line M1_R1 and the second power interconnection line M1_R2. The single height cell SHC may include a first active region AR1 and a second active region AR2. One of the first and second active regions AR1 and AR2 may be a PMOSFET region, and the other of the first and second active regions AR1 and AR2 may be an NMOSFET region. In other words, the single height cell SHC may have a CMOS structure provided between the first power interconnection line M1_R1 and the second power interconnection line M1_R2. For example, the first active region AR1 may be the NMOSFET region, and the second active region AR2 may be the PMOSFET region.

Each of the first and second active regions AR1 and AR2 may have a single width W_SHC in a first direction D1. A length of the single height cell SHC in the first direction D1 may be defined as a first height HE1. The first height HE1 may be substantially equal to a distance (e.g., a pitch) between the first power interconnection line M1_R1 and the second power interconnection line M1_R2.

The single height cell SHC may form a logic cell. In the present specification, the logic cell may mean a logic element (e.g., an AND element, an OR element, an XOR element, an XNOR element, an inverter, etc.) for performing a specific function. In other words, the logic cell may include transistors and interconnection lines connecting the transistors to each other, which constitute the logic element.

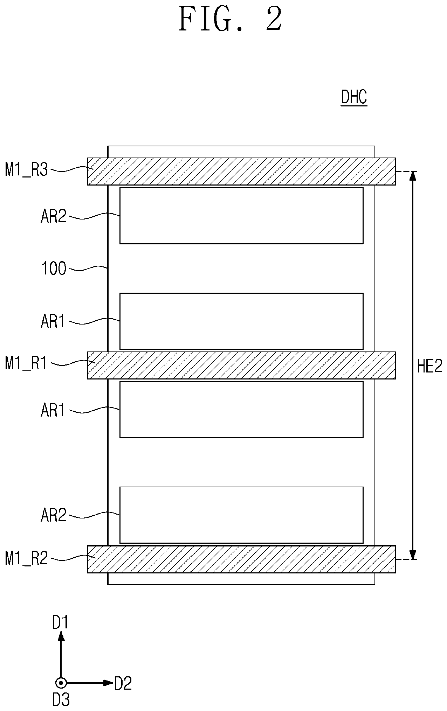

Referring to FIG. 2, a double height cell DHC may be provided. More particularly, a first power interconnection line M1_R1, a second power interconnection line M1_R2 and a third power interconnection line M1_R3 may be provided on a substrate 100. The first power interconnection line M1_R1 may be disposed between the second power interconnection line M1_R2 and the third power interconnection line M1_R3. The third power interconnection line M1_R3 may be a path through which a drain voltage (VDD) is provided.

The double height cell DHC may be defined between the second power interconnection line M1_R2 and the third power interconnection line M1_R3. The double height cell DHC may include two first active regions AR1 and two second active regions AR2.

One of the two second active regions AR2 may be adjacent to the second power interconnection line M1_R2. The other of the two second active regions AR2 may be adjacent to the third power interconnection line M1_R3. The two first active regions AR1 may be adjacent to the first power interconnection line M1_R1. The first power interconnection line M1_R1 may be disposed between the two first active regions AR1 when viewed in a plan view.

A length of the double height cell DHC in the first direction D1 may be defined as a second height HE2. The second height HE2 may be about twice the first height HE1 of FIG. 1. The two first active regions AR1 of the double height cell DHC may be combined with each other to operate as a single active region.

In the inventive concepts, the double height cell DHC shown in FIG. 2 may be defined as a multi-height cell. Even though not shown in the drawings, the multi-height cell may include a triple height cell of which a cell height is about three times that of the single height cell SHC.

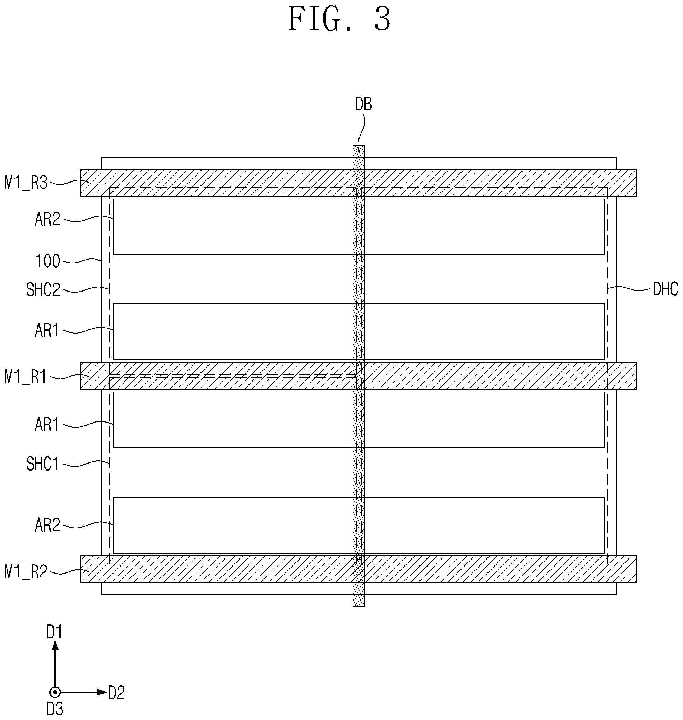

Referring to FIG. 3, a first single height cell SHC1, a second single height cell SHC2 and a double height cell DHC may be two-dimensionally disposed on a substrate 100. The first single height cell SHC1 may be disposed between the first and second power interconnection lines M1_R1 and M1_R2. The second single height cell SHC2 may be disposed between the first and third power interconnection lines M1_R1 and M1_R3. The second single height cell SHC2 may be adjacent to the first single height cell SHC1 in the first direction D1.

The double height cell DHC may be disposed between the second and third power interconnection lines M1_R2 and M1_R3. The double height cell DHC may be adjacent to the first and second single height cells SHC1 and SHC2 in a second direction D2.

An isolation structure DB may be provided between the first single height cell SHC1 and the double height cell DHC and between the second single height cell SHC2 and the double height cell DHC. An active region of the double height cell DHC may be electrically isolated from an active region of each of the first and second single height cells SHC1 and SHC2 by the isolation structure DB.

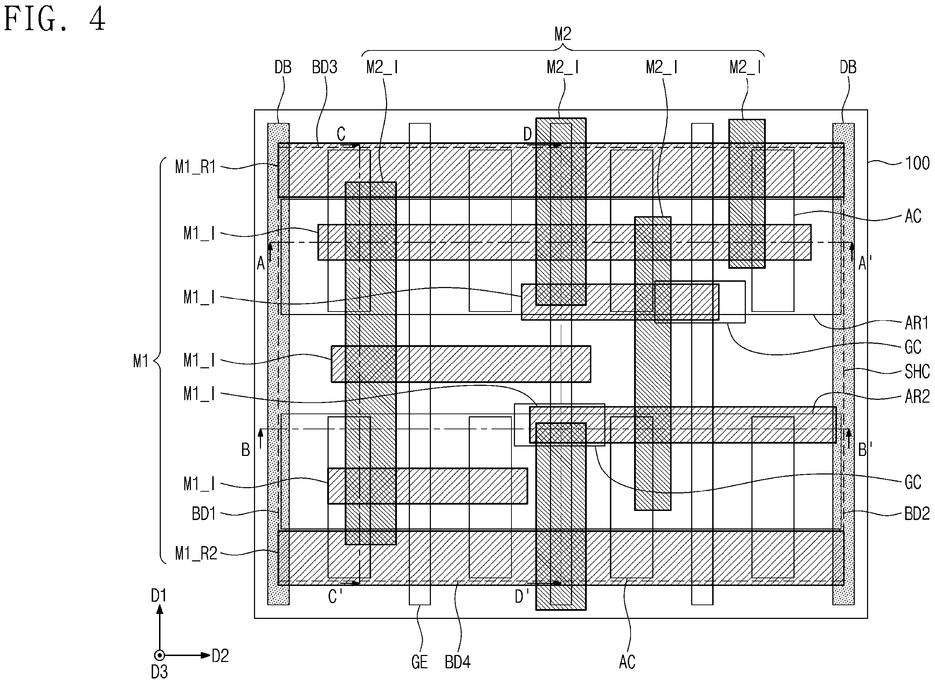

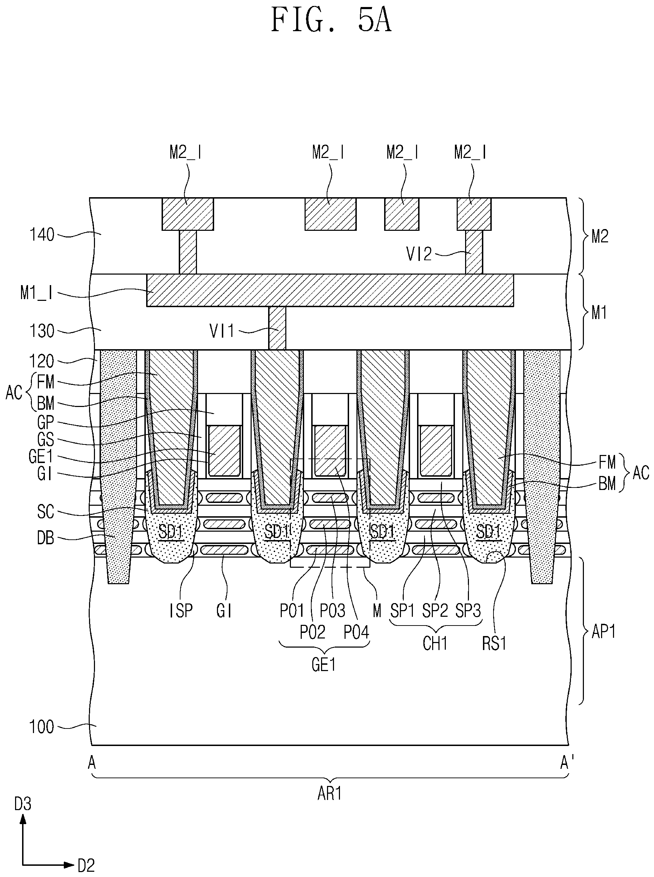

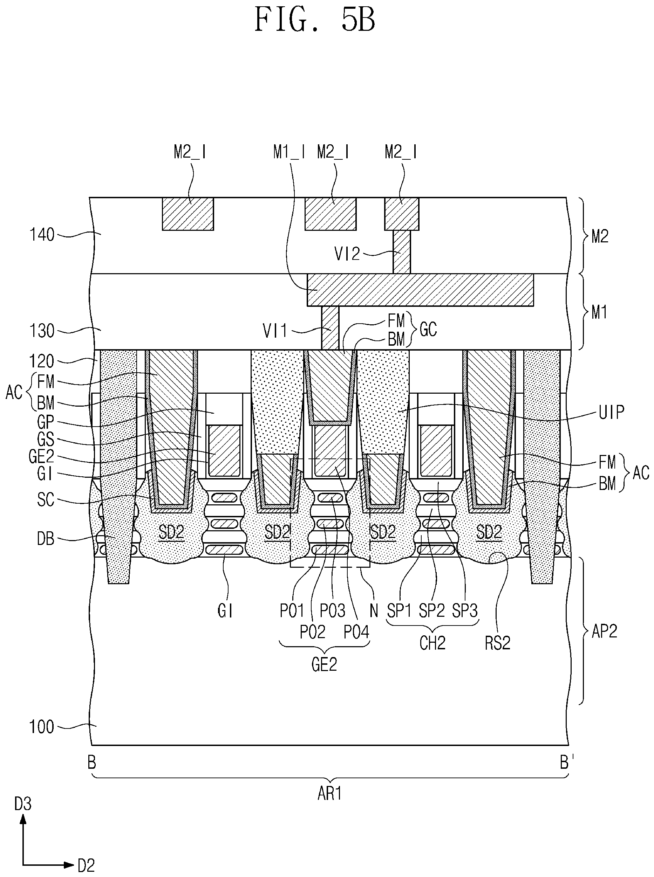

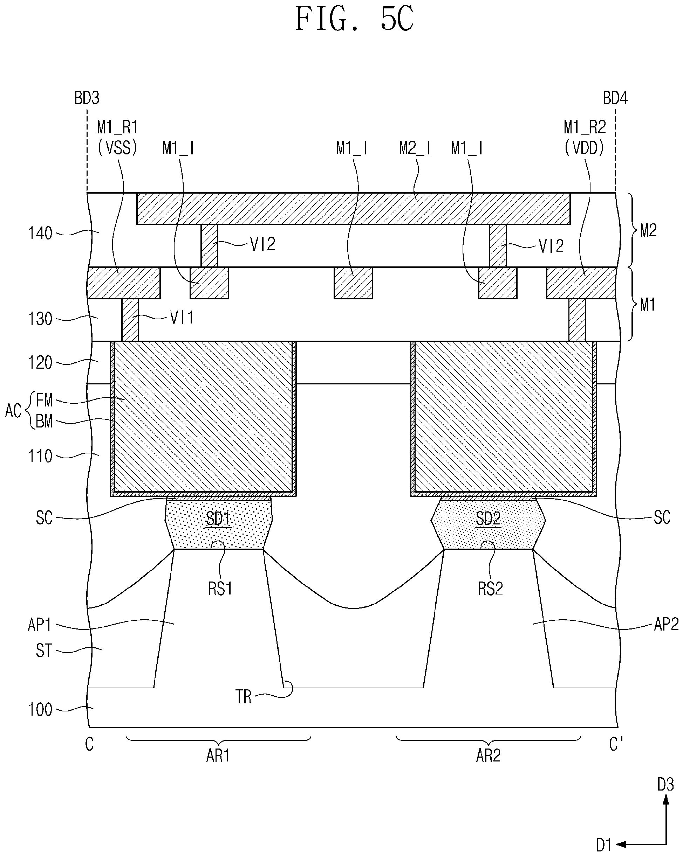

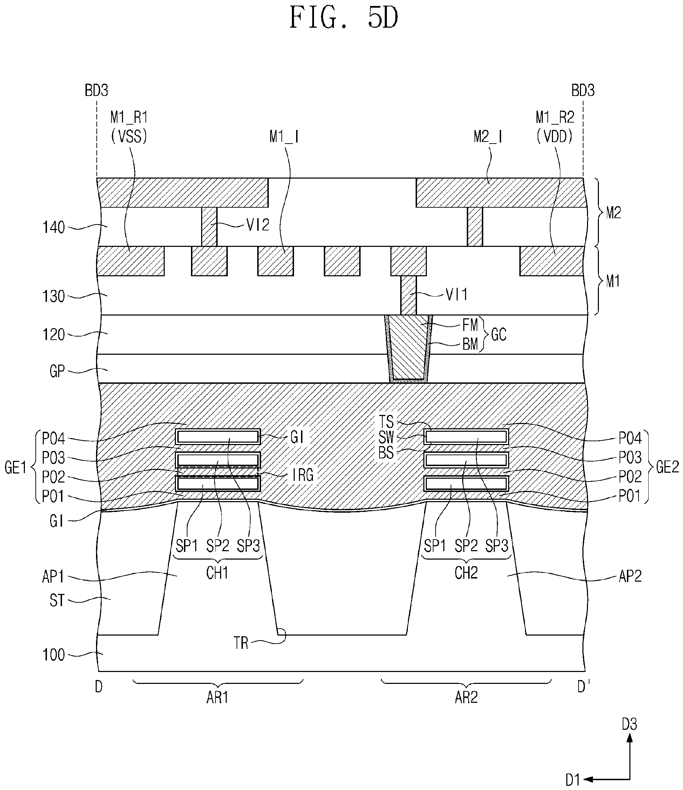

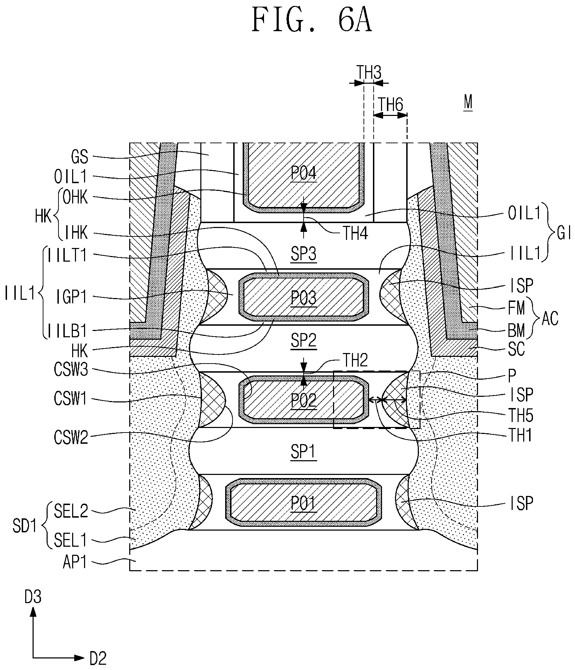

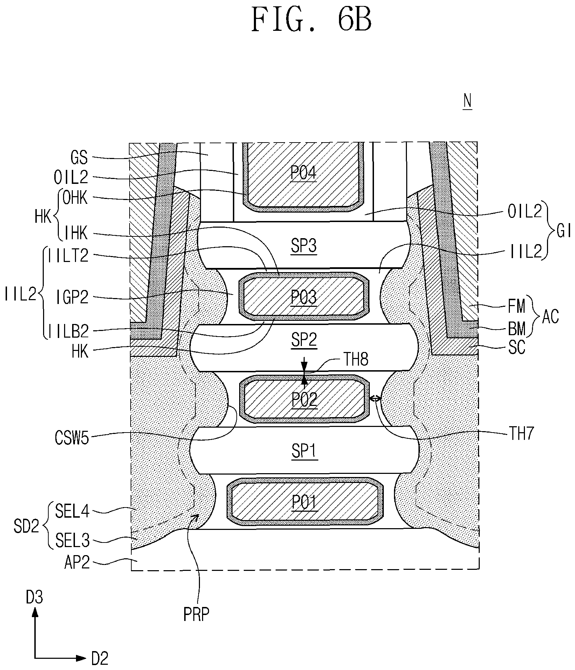

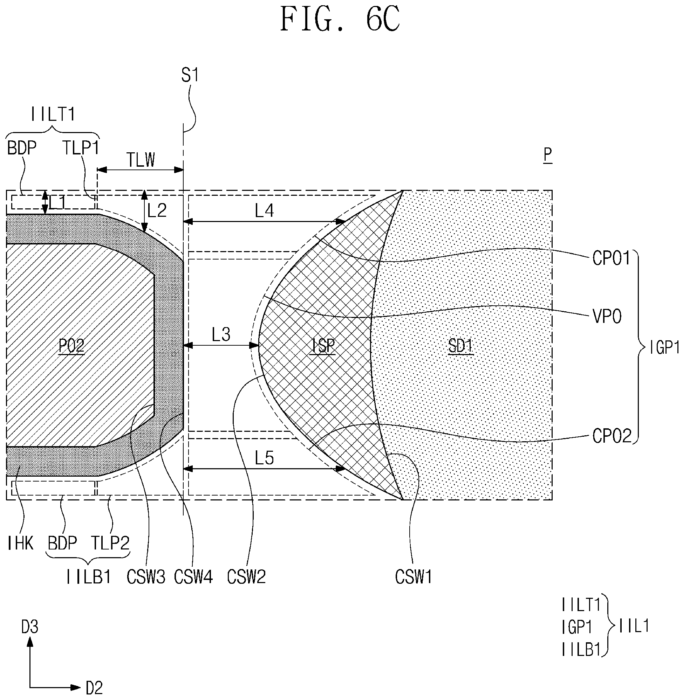

FIG. 4 is a plan view illustrating a semiconductor device according to some embodiments of the inventive concepts. FIGS. 5A, 5B, 5C and 5D are cross-sectional views taken along lines A-A', B-B', C-C' and D-D' of FIG. 4, respectively. FIG. 6A is an enlarged view illustrating an embodiment of a region 'M' of FIG. 5A, and FIG. 6B is an enlarged view illustrating an embodiment of a region 'N' of FIG. 5B. FIG. 6C is an enlarged view illustrating an embodiment of a region 'P' of FIG. 6A. A semiconductor device shown in FIGS. 4 and 5A to 5D may correspond to a more detailed embodiment of the single height cell SHC of FIG. 1.

Referring to FIGS. 4 and 5A to 5D, a single height cell SHC may be provided on a substrate 100. Logic transistors that include a logic circuit may be disposed on the single height cell SHC. The substrate 100 may be a semiconductor substrate including silicon, germanium or silicon-germanium, or a compound semiconductor substrate. For example, the substrate 100 may be a silicon substrate.

The substrate 100 may include a first active region AR1 and a second active region AR2. Each of the first and second active regions AR1 and AR2 may extend in the second direction D2. In some embodiments, the first active region AR1 may be an NMOSFET region, and the second active region AR2 may be a PMOSFET region.

A first active pattern AP1 and a second active pattern AP2 may be defined by a trench TR formed in an upper portion of the substrate 100. The first active pattern AP1 may be provided on the first active region AR1, and the second active pattern AP2 may be provided on the second active region AR2. The first and second active patterns AP1 and AP2 may extend in the second direction D2. The first and second active patterns AP1 and AP2 may be portions of the substrate 100, which vertically protrude.

A device isolation layer ST may be provided on the substrate 100. The device isolation layer ST may fill the trench TR. The device isolation layer ST may include a silicon oxide layer. The device isolation layer ST may not cover or may not overlap first and second channel patterns CH1 and CH2 to be described below.

A first channel pattern CH1 may be provided on the first active pattern AP1. A second channel pattern CH2 may be provided on the second active pattern AP2. Each of the first channel pattern CH1 and the second channel pattern CH2 may include a first semiconductor pattern SP1, a second semiconductor pattern SP2 and a third semiconductor pattern SP3, which are sequentially stacked. The first to third semiconductor patterns SP1, SP2 and SP3 may be spaced apart from each other in a vertical direction (i.e., a third direction D3).

Each of the first to third semiconductor patterns SP1, SP2 and SP3 may include silicon (Si), germanium (Ge), or silicon-germanium (SiGe). For example, each of the first to third semiconductor patterns SP1, SP2 and SP3 may include crystalline silicon. In some embodiments of the inventive concepts, the first to third semiconductor patterns SP1, SP2 and SP3 may be stacked nanosheets.

A plurality of first source/drain patterns SD1 may be provided on the first active pattern AP1. A plurality of first recesses RS1 may be formed on the first active pattern AP1. The first source/drain patterns SD1 may be provided in the first recesses RS1, respectively. The first source/drain patterns SD1 may be dopant regions having a first conductivity type (e.g., an n-type). The first channel pattern CH1 may be disposed between a pair of the first source/drain patterns SD1. In other words, the first to third semiconductor patterns SP1, SP2 and SP3 stacked sequentially may connect the pair of first source/drain patterns SD1 to each other.

A plurality of second source/drain patterns SD2 may be provided on the second active pattern AP2. A plurality of second recesses RS2 may be formed on the second active pattern AP2. The second source/drain patterns SD2 may be provided in the second recesses RS2, respectively. The second source/drain patterns SD2 may be dopant regions having a second conductivity type (e.g., a p-type). The second channel pattern CH2 may be disposed between a pair of the second source/drain patterns SD2. In other words, the first to third semiconductor patterns SP1, SP2 and SP3 stacked sequentially may connect the pair of second source/drain patterns SD2 to each other.

The first and second source/drain patterns SD1 and SD2 may be epitaxial patterns formed by a selective epitaxial growth (SEG) process. In some embodiments, a top surface of each of the first and second source/drain patterns SD1 and SD2 may be higher than a top surface of the third semiconductor pattern SP3. In certain embodiments, the top surface of at least one of the first and second source/drain patterns SD1 and SD2 may be located at substantially the same level as the top surface of the third semiconductor pattern SP3.

In some embodiments of the inventive concepts, the first source/drain patterns SD1 may include the same semiconductor element (e.g., Si) as the substrate 100. The second source/drain patterns SD2 may include a semiconductor element (e.g., SiGe) having a lattice constant greater than a lattice constant of the semiconductor element (e.g., Si) of the substrate 100. Thus, the pair of second source/drain patterns SD2 may provide compressive stress to the second channel pattern CH2 therebetween.

In some embodiments of the inventive concepts, a sidewall of the second source/drain pattern SD2 may have an uneven embossing shape. In other words, the sidewall of the second source/drain pattern SD2 may have a wave-shaped profile. The sidewall of the second source/drain pattern SD2 may protrude toward first to third inner gate electrodes PO1, PO2 and PO3 of a second gate electrode GE2 to be described below.

First and second gate electrodes GE1 and GE2 may be provided on the first and second channel patterns CH1 and CH2, respectively. The first and second gate electrodes GE1 and GE2 may intersect the first and second channel patterns CH1 and CH2 and may extend in the first direction D1. The first and second gate electrodes GE1 and GE2 may vertically overlap with the first and second channel patterns CH1 and CH2, respectively. Gate electrodes GE, each of which includes the first and second gate electrodes GE1 and GE2, may be arranged in the second direction D2 at a first pitch.

Each of the first and second gate electrodes GE1 and GE2 may include a first inner gate electrode PO1 disposed between the active pattern AP1 or AP2 and the first semiconductor pattern SP1, a second inner gate electrode PO2 disposed between the first semiconductor pattern SP1 and the second semiconductor pattern SP2, a third inner gate electrode PO3 disposed between the second semiconductor pattern SP2 and the third semiconductor pattern SP3, and an outer gate electrode PO4 on the third semiconductor pattern SP3.

Referring to FIG. 5D, each of the first and second gate electrodes GE1 and GE2 may be provided on a top surface TS, a bottom surface BS and both sidewalls SW of each of the first to third semiconductor patterns SP1, SP2 and SP3. In other words, the transistor according to the present embodiments may be a three-dimensional field effect transistor (e.g., a multibridge-channel metal-oxide-semiconductor field-effect transistor (MBCFET) or a Gate-all-around field-effect transistor (GAAFET)) in which each of the first and second gate electrodes GE1 and GE2 three-dimensionally surrounds a channel.

Inner spacers ISP may be disposed between the first source/drain pattern SD1 and the first to third inner gate electrodes PO1, PO2 and PO3 of the first gate electrode GE1, respectively, on the first active region AR1. Each of the first to third inner gate electrodes PO1, PO2 and PO3 of the first gate electrode GE1 may be spaced apart from the first source/drain pattern SD1 with the inner spacer ISP interposed therebetween. The inner spacer ISP may prevent a leakage current from the first gate electrode GE1. The inner spacer ISP according to the inventive concepts will be described below in more detail with reference to FIGS. 6A and 6C.

Referring again to FIGS. 4 and 5A, 5B, 5C, and 5D, a pair of gate spacers GS may be disposed on both sidewalls of the outer gate electrode PO4 of each of the first and second gate electrodes GE1 and GE2, respectively. The gate spacers GS may extend in the first direction D1 along the first and second gate electrodes GE1 and GE2. Top surfaces of the gate spacers GS may be higher than top surfaces of the first and second gate electrodes GE1 and GE2. The top surfaces of the gate spacers GS may be coplanar with a top surface of a first interlayer insulating layer 110 to be described below. For some examples, the gate spacers GS may include at least one of SiCN, SiCON, or SiN. For certain examples, each of the gate spacers GS may include a multi-layer formed of at least two of SiCN, SiCON, or SiN.

Referring again to FIGS. 4 and 5A, 5B, 5C, and 5D, a gate capping pattern GP may be provided on the first and second gate electrodes GE1 and GE2. The gate capping pattern GP may extend in the first direction D1 along the first and second gate electrodes GE1 and GE2. The gate capping pattern GP may include a material having an etch selectivity with respect to first and second interlayer insulating layers 110 and 120 to be described below. For example, the gate capping pattern GP may include at least one of SiON, SiCN, SiCON, or SiN.

A gate insulating layer GI may be disposed between the first gate electrode GE1 and the first channel pattern CH1 and between the second gate electrode GE2 and the second channel pattern CH2. The gate insulating layer GI may cover, be on, or overlap the top surface TS, the bottom surface BS and the both sidewalls SW of each of the first to third semiconductor patterns SP1, SP2 and SP3. The gate insulating layer GI may cover, be on, or overlap a top surface of the device isolation layer ST under the gate electrode GE. The gate insulating layer GI according to the inventive concepts will be described below in more detail with reference to FIGS. 6A, 6B, and 6C.

A high-k dielectric layer may be disposed between the gate insulating layer GI and each of the gate electrodes GE1 and GE2. In certain embodiments, the gate insulating layer GI may have a structure in which a silicon oxide layer and the high-k dielectric layer are stacked. The high-k dielectric layer according to the inventive concepts will be described below in more detail with reference to FIGS. 6A and 6B.

The high-k dielectric layer (see HK of FIGS. 6A and 6B) may include a high-k dielectric material having a dielectric constant higher than that of the silicon oxide layer. For example, the high-k dielectric material may include at least one of hafnium oxide, hafnium silicon oxide, hafnium zirconium oxide, hafnium tantalum oxide, lanthanum oxide, zirconium oxide, zirconium silicon oxide, tantalum oxide, titanium oxide, barium strontium titanium oxide, barium titanium oxide, strontium titanium oxide, lithium oxide, aluminum oxide, lead scandium tantalum oxide, or lead zinc niobate.

In certain embodiments, the semiconductor device according to the inventive concepts may include a negative capacitance (NC) FET using a negative capacitor. For example, the gate insulating layer GI may include a ferroelectric material layer having ferroelectric properties, and a paraelectric material layer having paraelectric properties.

The ferroelectric material layer may have a negative capacitance, and the paraelectric material layer may have a positive capacitance. For example, when two or more capacitors are connected in series to each other and a capacitance of each of the capacitors has a positive value, a total capacitance may be reduced to be less than the capacitance of each of the capacitors. On the contrary, when at least one of capacitances of two or more capacitors connected in series to each other has a negative value, a total capacitance may have a positive value and may be greater than an absolute value of the capacitance of each of the capacitors.

When the ferroelectric material layer having the negative capacitance is connected in series to the paraelectric material layer having the positive capacitance, a total capacitance value of the ferroelectric and paraelectric material layers connected in series may increase. The transistor including the ferroelectric material layer may have a subthreshold swing (SS) less than 60 mV/decade at room temperature by using the increase in the total capacitance value.

The ferroelectric material layer may have the ferroelectric properties. For example, the ferroelectric material layer may include at least one of hafnium oxide, hafnium zirconium oxide, barium strontium titanium oxide, barium titanium oxide, or lead zirconium titanium oxide. Here, for an example, the hafnium zirconium oxide may be a material formed by doping hafnium oxide with zirconium (Zr). For another example, the hafnium zirconium oxide may be a compound of hafnium (Hf), zirconium (Zr), and oxygen (O).

The ferroelectric material layer may further include dopants doped therein. For example, the dopants may include at least one of aluminum (Al), titanium (Ti), niobium (Nb), lanthanum (La), yttrium (Y), magnesium (Mg), silicon (Si), calcium (Ca), cerium (Ce), dysprosium (Dy), erbium (Er), gadolinium (Gd), germanium (Ge), scandium (Sc), strontium (Sr), or tin (Sn). A kind of the dopants included in the ferroelectric material layer may be changed depending on a kind of the ferroelectric material included in the ferroelectric material layer.

When the ferroelectric material layer includes hafnium oxide, the dopants included in the ferroelectric material layer may include at least one of, for example, gadolinium (Gd), silicon (Si), zirconium (Zr), aluminum (Al), or yttrium (Y).

When the dopants are aluminum (Al), the ferroelectric material layer may include aluminum of 3 at% (atomic %) to 8 at%. Here, a ratio of the dopants may be a ratio of the amount of aluminum to a sum of the amounts of hafnium and aluminum.

When the dopants are silicon (Si), the ferroelectric material layer may include silicon of 2 at% to 10 at%. When the dopants are yttrium (Y), the ferroelectric material layer may include yttrium of 2 at% to 10 at%. When the dopants are gadolinium (Gd), the ferroelectric material layer may include gadolinium of 1 at% to 7 at%. When the dopants are zirconium (Zr), the ferroelectric material layer may include zirconium of 50 at% to 80 at%.

The paraelectric material layer may have the paraelectric properties. For example, the paraelectric material layer may include at least one of silicon oxide or a metal oxide having a high-k dielectric constant. For example, the metal oxide included in the paraelectric material layer may include at least one of, but not limited to, hafnium oxide, zirconium oxide, or aluminum oxide.

The ferroelectric material layer and the paraelectric material layer may include the same material. The ferroelectric material layer may have the ferroelectric properties, but the paraelectric material layer may not have the ferroelectric properties. For example, when the ferroelectric material layer and the paraelectric material layer include hafnium oxide, a crystal structure of hafnium oxide included in the ferroelectric material layer may be different from a crystal structure of hafnium oxide included in the paraelectric material layer.

The ferroelectric material layer may have a thickness showing the ferroelectric properties. For example, the thickness of the ferroelectric material layer may range from 0.5nm to 10nm, but embodiments of the inventive concepts are not limited thereto. A critical thickness showing the ferroelectric properties may be changed depending on a kind of a ferroelectric material, and thus the thickness of the ferroelectric material layer may be changed depending on a kind of the ferroelectric material included therein.

In some examples, the gate insulating layer GI may include a single ferroelectric material layer. For certain examples, the gate insulating layer GI may include a plurality of the ferroelectric material layers spaced apart from each other. The gate insulating layer GI may have a stack structure in which the ferroelectric material layers and the paraelectric material layers are alternately stacked.

Referring again to FIGS. 4 and 5A, 5B, 5C, and 5D, each of the first and second gate electrodes GE1 and GE2 may include a first metal pattern and a second metal pattern on the first metal pattern. The first metal pattern may be provided on the gate insulating layer GI and may be adjacent to the first to third semiconductor patterns SP1, SP2 and SP3. The first metal pattern may include a work function metal of adjusting a threshold voltage of a transistor. A desired threshold voltage of the transistor may be obtained by adjusting a thickness and a composition of the first metal pattern. For example, the first to third inner gate electrodes PO1, PO2 and PO3 of the first and second gate electrodes GE1 and GE2 may be formed of the first metal pattern having the work function metal.

The first metal pattern of the first and second gate electrodes GE1 and GE2 may include a metal nitride layer. For example, the first metal pattern may include nitrogen (N) and at least one metal selected from a group consisting of titanium (Ti), tantalum (Ta), aluminum (Al), tungsten (W), and/or molybdenum (Mo). In addition, the first metal pattern may further include carbon (C). In some embodiments, the first metal pattern may include a plurality of stacked work function metal layers.

The second metal pattern of the first and second gate electrodes GE1 and GE2 may include a metal having a resistance lower than that of the first metal pattern. For example, the second metal pattern may include at least one metal selected from a group consisting of tungsten (W), aluminum (Al), titanium (Ti), and/or tantalum (Ta). For example, the outer gate electrodes PO4 of the first and second gate electrodes GE1 and GE2 may include the first metal pattern and the second metal pattern on the first metal pattern.

A first interlayer insulating layer 110 may be provided on the substrate 100. The first interlayer insulating layer 110 may cover, be on, or overlap the gate spacers GS and the first and second source/drain patterns SD1 and SD2. A top surface of the first interlayer insulating layer 110 may be substantially coplanar with the top surface of the gate capping pattern GP and the top surface of the gate spacer GS. A second interlayer insulating layer 120 covering or overlapping the gate capping pattern GP may be disposed on the first interlayer insulating layer 110. A third interlayer insulating layer 130 may be provided on the second interlayer insulating layer 120. A fourth interlayer insulating layer 140 may be provided on the third interlayer insulating layer 130. For example, each of the first to fourth interlayer insulating layers 110 to 140 may include a silicon oxide layer.

The single height cell SHC may have a first boundary BD1 and a second boundary BD2, which are opposite to each other in the second direction D2. The first and second boundaries BD1 and BD2 may extend in the first direction D1. The single height cell SHC may have a third boundary BD3 and a fourth boundary BD4, which are opposite to each other in the first direction D1. The third and fourth boundaries BD3 and BD4 may extend in the second direction D2.

A pair of isolation structures DB opposite to each other in the second direction D2 may be provided at both sides of the single height cell SHC, respectively. For example, the pair of isolation structures DB may be provided on the first and second boundaries BD1 and BD2 of the single height cell SHC, respectively. The isolation structure DB may extend in the first direction D1 in parallel to the first and second gate electrodes GE1 and GE2. A pitch between the isolation structure DB and the first and second gate electrodes GE1 and GE2 adjacent thereto may be equal to the first pitch.

The isolation structure DB may penetrate the first and second interlayer insulating layers 110 and 120 and may extend into the first and second active patterns AP1 and AP2. The isolation structure DB may penetrate an upper portion of each of the first and second active patterns AP1 and AP2. The isolation structure DB may electrically isolate the active region of the single height cell SHC from an active region of another cell adjacent thereto.

Active contacts AC may penetrate the first and second interlayer insulating layers 110 and 120 so as to be electrically connected to the first and second source/drain patterns SD1 and SD2. A pair of the active contacts AC may be provided at both sides of the gate electrode GE, respectively. The active contact AC may have a bar shape extending in the first direction D1 when viewed in a plan view.

The active contact AC may be a self-aligned contact. In other words, the active contact AC may be formed to be self-aligned with the gate capping pattern GP and the gate spacer GS. For example, the active contact AC may cover or overlap at least a portion of a sidewall of the gate spacer GS. Even though not shown in the drawings, the active contact AC may cover or overlap a portion of the top surface of the gate capping pattern GP.

Metal-semiconductor compound layers SC (e.g., silicide layers) may be disposed between the active contact AC and the first source/drain pattern SD1 and between the active contact AC and the second source/drain pattern SD2, respectively. The active contact AC may be electrically connected to the source/drain pattern SD1 or SD2 through the metal-semiconductor compound layer SC. For example, the metal-semiconductor compound layer SC may include at least one of titanium silicide, tantalum silicide, tungsten silicide, nickel silicide, or cobalt silicide.

Gate contacts GC may penetrate the second interlayer insulating layer 120 and the gate capping patterns GP so as to be electrically connected to the gate electrodes GE, respectively. The gate contacts GC may overlap with the first active region AR1 and the second active region AR2, respectively, when viewed in a plan view. For example, the gate contact GC may be provided on the second active pattern AP2 (see FIG. 5B).

In some embodiments of the inventive concepts, referring to FIG. 5B, an upper portion of the active contact AC adjacent to the gate contact GC may be filled with an upper insulating pattern UIP. A bottom surface of the upper insulating pattern UIP may be lower than a bottom surface of the gate contact GC. In other words, a top surface of the active contact AC adjacent to the gate contact GC may be lower than the bottom surface of the gate contact GC due to the upper insulating pattern UIP. Thus, it is possible to prevent an electrical short between the gate contact GC and the active contact AC adjacent thereto.

Each of the active contact AC and the gate contact GC may include a conductive pattern FM and a barrier pattern BM surrounding the conductive pattern FM. For example, the conductive pattern FM may include at least one metal of aluminum, copper, tungsten, molybdenum, or cobalt. The barrier pattern BM may cover, overlap, or be on sidewalls and a bottom surface of the conductive pattern FM. The barrier pattern BM may include a metal layer and/or a metal nitride layer. The metal layer may include at least one of titanium, tantalum, tungsten, nickel, cobalt, or platinum. The metal nitride layer may include at least one of a titanium nitride (TiN) layer, a tantalum nitride (TaN) layer, a tungsten nitride (WN) layer, a nickel nitride (NiN) layer, a cobalt nitride (CoN) layer, or a platinum nitride (PtN) layer.

A first metal layer M1 may be provided in the third interlayer insulating layer 130. For example, the first metal layer M1 may include a first power interconnection line M1_R1, a second power interconnection line M1_R2, and first interconnection lines M1_I. The interconnection lines M1_R1, M1_R2 and M1_I of the first metal layer M1 may extend in the second direction D2 in parallel to each other.

More particularly, the first and second power interconnection lines M1_R1 and M1_R2 may be provided on the third and fourth boundaries BD3 and BD4 of the single height cell SHC, respectively. The first power interconnection line M1_R1 may extend in the second direction D2 along the third boundary BD3. The second power interconnection line M1_R2 may extend in the second direction D2 along the fourth boundary BD4.

The first interconnection lines M1_I of the first metal layer M1 may be disposed between the first and second power interconnection lines M1_R1 and M1_R2. The first interconnection lines M1_I of the first metal layer M1 may be arranged in the first direction D1 at a second pitch. The second pitch may be less than the first pitch. A line width of each of the first interconnection lines M1_I may be less than a line width of each of the first and second power interconnection lines M1_R1 and M1_R2.

The first metal layer M1 may further include first vias VI1. The first vias VI1 may be provided under the interconnection lines M1_R1, M1_R2 and M1_I of the first metal layer M1. The active contact AC may be electrically connected to a corresponding one of the interconnection lines of the first metal layer M1 through a corresponding one of the first vias VI1. The gate contact GC may be electrically connected to a corresponding one of the interconnection lines of the first metal layer M1 through a corresponding one of the first vias VI1.

The interconnection line of the first metal layer M1 and the first via VI1 thereunder may be formed using different processes. In other words, each of the interconnection line and the first via VI1 of the first metal layer M1 may be formed using a single damascene process. The semiconductor device according to the present embodiments may be formed using processes less than 20nm.

A second metal layer M2 may be provided in the fourth interlayer insulating layer 140. The second metal layer M2 may include a plurality of second interconnection lines M2_I. Each of the second interconnection lines M2_I of the second metal layer M2 may have a line shape or bar shape extending in the first direction D1. In other words, the second interconnection lines M2_I may extend in the first direction D1 in parallel to each other.

The second metal layer M2 may further include second vias VI2 provided under the second interconnection lines M2_I. The interconnection lines of the first metal layer M1 may be electrically connected to the interconnection lines of the second metal layer M2 through the second vias VI2. For example, the interconnection line of the second metal layer M2 and the second via VI2 thereunder may be formed together by a dual damascene process.

The interconnection line of the first metal layer M1 and the interconnection line of the second metal layer M2 may include the same conductive material or different conductive materials. For example, the interconnection lines of the first metal layer M1 and the interconnection lines of the second metal layer M2 may include at least one metal material of aluminum, copper, tungsten, molybdenum, ruthenium, or cobalt. Even though not shown in the drawings, metal layers (e.g., M3, M4, M5, ...) stacked on the fourth interlayer insulating layer 140 may be additionally provided. Each of the stacked metal layers may include interconnection lines for routing between cells.

The first and second source/drain patterns SD1 and SD2, the gate insulating layer GI, the high-k dielectric layer HK and the inner spacers ISP will be described in more detail with reference to FIGS. 6A, 6B, and 6C. Due to the inner spacers ISP, the first source/drain pattern SD1 may not protrude between the semiconductor patterns SP1 to SP3 adjacent to each other. The second source/drain pattern SD2 may include protrusions PRP protruding toward the first to third inner gate electrodes PO1 to PO3 of the second gate electrode GE2, respectively.

The first source/drain pattern SD1 may have a first sidewall CSW1 shared with the inner spacer ISP. The protrusion PRP of the second source/drain pattern SD2 may have a fifth sidewall CSW5. The fifth sidewall CSW5 according to the present embodiments may be convex toward a corresponding one of the first to third inner gate electrodes PO1, PO2 and PO3 of the second gate electrode GE2.

In some embodiments of the inventive concepts, the first to third inner gate electrodes PO1, PO2 and PO3 may have different widths. For example, a maximum width of the first inner gate electrode PO1 in the second direction D2 may be greater than a maximum width of the second inner gate electrode PO2 in the second direction D2. The maximum width of the second inner gate electrode PO2 in the second direction D2 may be greater than a maximum width of the third inner gate electrode PO3 in the second direction D2.

The first source/drain pattern SD1 may include a first semiconductor layer SEL1 and a second semiconductor layer SEL2 on the first semiconductor layer SEL1. In some embodiments, in the case in which the first source/drain pattern SD1 has the n-type, the first semiconductor layer SEL1 may include the same semiconductor material (e.g., silicon (Si)) as the second semiconductor layer SEL2. However, a concentration of n-type dopants (e.g., phosphorus or arsenic) of the second semiconductor layer SEL2 may be greater than a concentration of n-type dopants of the first semiconductor layer SEL1.

The second source/drain pattern SD2 may include a third semiconductor layer SEL3 and a fourth semiconductor layer SEL4 on the third semiconductor layer SEL3. In some embodiments, in the case in which the second source/drain pattern SD2 has the p-type, the third semiconductor layer SEL3 may include the same semiconductor material (e.g., silicon-germanium (SiGe)) as the fourth semiconductor layer SEL4. However, a germanium concentration of the fourth semiconductor layer SEL4 may be greater than a germanium concentration of the third semiconductor layer SEL3. In addition, a concentration of p-type dopants (e.g., boron) of the fourth semiconductor layer SEL4 may be greater than a concentration of p-type dopants of the third semiconductor layer SEL3.

The third semiconductor layer SEL3 may be in direct contact with the first to third semiconductor patterns SP1, SP2 and SP3. The third semiconductor layer SEL3 may include the protrusions PRP described above. A second inner gate spacer IGP2 to be described below may directly cover or overlap the third semiconductor layer SEL3. The first to third inner gate electrodes PO1, PO2 and PO3 of the second gate electrode GE2 may be spaced apart from the third semiconductor layer SEL3 with the second inner gate spacer IGP2 interposed therebetween.

The gate insulating layer GI may include a silicon (Si)-containing insulating material. For example, the gate insulating layer GI may include SiOₓ, SiₓN_{y}, SiₓO_{y}C_{z}Nᵥ, or any combination thereof.

The gate insulating layer GI may include a first inner gate insulating layer IIL1 between the first to third semiconductor patterns SP1, SP2 and SP3 of the first channel pattern CH1 and the first to third inner gate electrodes PO1, PO2 and PO3 of the first gate electrode GE1, and a first outer gate insulating layer OII,1 between the third semiconductor pattern SP3 and the outer gate electrode PO4 of the first gate electrode GE1.

In addition, the gate insulating layer GI may include a second inner gate insulating layer IIL2 between the first to third semiconductor patterns SP1, SP2 and SP3 of the second channel pattern CH2 and the first to third inner gate electrodes PO1, PO2 and PO3 of the second gate electrode GE2, and a second outer gate insulating layer OIL2 between the third semiconductor pattern SP3 and the outer gate electrode PO4 of the second gate electrode GE2.

Each of the first and second outer gate insulating layers OIL1 and OIL2 may be provided on a bottom surface and sidewalls of the outer gate electrode PO4. Each of the first and second outer gate insulating layers OIL1 and OIL2 may extend onto the gate capping pattern GP (see FIGS. 5A and 5B) covering, overlapping, or on a top surface of the outer gate electrode PO4.

Each of the first and second inner gate insulating layers IIL1 and IIL2 may be provided between the first to third semiconductor patterns SP1 to SP3 and the first to third inner gate electrodes PO1 to PO3. In other words, each of the first and second inner gate insulating layers IIL1 and IIL2 may surround each of the first to third inner gate electrodes PO1 to PO3.

More particularly, the first inner gate insulating layer IIL1 may include a first upper insulating layer IILT1 on one of the first to third inner gate electrodes PO1 to PO3, a first lower insulating layer IILB1 provided under the one inner gate electrode, and a first inner gate spacer IGP1 on both sidewalls of the one inner gate electrode.

The second inner gate insulating layer IIL2 may include a second upper insulating layer III,T2 on one of the first to third inner gate electrodes PO1 to PO3, a second lower insulating layer III,B2 provided under the one inner gate electrode, and the second inner gate spacer IGP2 on both sidewalls of the one inner gate electrode.

Referring to FIG. 6C, each of the first upper insulating layer IILT1 and the first lower insulating layer IILB 1 may include a body portion BDP parallel to a top surface or bottom surface of the second inner gate electrode PO2, and tail portions TLP1 or TLP2 provided at both sides of the body portion BDP. More particularly, the first upper insulating layer IILT1 may include a first tail portion TLP1, and the first lower insulating layer IILB1 may include a second tail portion TLP2.

Each of the first and second tail portions TLP1 and TLP2 may be located between the body portion BDP and the first inner gate spacer IGP1. In other words, each of the first and second tail portions TLP1 and TLP2 may connect the body portion BDP and the first inner gate spacer IGP1.

The body portion BDP may have a first length L1 in the third direction D3 corresponding to a direction perpendicular to a bottom surface of the substrate 100, and each of the tail portions TLP1 and TLP2 may have a second length L2 in the third direction D3. Each of the first length L1 and the second length L2 may be defined as the shortest length from a top surface of an inner high-k dielectric layer IHK to the bottom surface of the closest one of the first to third semiconductor patterns SP1 to SP3.

The top surface or a bottom surface of the inner high-k dielectric layer IHK, which vertically overlaps with the body portion BDP, may be a flat surface, and thus the first length L1 may have a uniform value. The top surface of the inner high-k dielectric layer IHK, which vertically overlaps with the first tail portion TLP1, may be a curved surface, and thus the second length L2 may gradually increase toward the second direction D2 intersecting the third direction D3.

The first length L1 may have a constant value, and the second length L2 may have a changing value. In other words, a variation in the second length L2 according to a predetermined horizontal distance TLW may be greater than a variation in the first length L1 according to the predetermined horizontal distance TLW. For example, the predetermined horizontal distance TLW may range from 1nm to 3nm.

In certain embodiments of the inventive concepts, the second length L2 may have a value very close to the first length L1. For example, a ratio (L2/L1) of the second length L2 to the first length L1 may range from 1 to 2 (in particular, may range from 1.1 to 1.5).

The first inner gate spacer IGP1 may include a vertical portion VPO, a first corner portion CPO1 provided on the vertical portion VPO, and a second corner portion CPO2 provided under the vertical portion VPO. The first tail portion TLP1 described above may be located between the body portion BDP and the first corner portion CPO1 of the first inner gate spacer IGP1. The second tail portion TLP2 described above may be located between the body portion BDP and the second corner portion CPO2 of the first inner gate spacer IGP1.

The vertical portion VPO may have a third length L3 in the second direction D2 corresponding to a direction parallel to the bottom surface of the substrate 100. The first corner portion CPO1 may have a fourth length L4 in the second direction D2, and the second corner portion CPO2 may have a fifth length L5 in the second direction D2. The third length L3 may be defined as the shortest length from a fourth sidewall CSW4 of the inner high-k dielectric layer IHK to a second sidewall CSW2 of the inner spacer ISP. Each of the fourth length L4 and the fifth length L5 may be defined as the shortest length from a base line S1, extending from the fourth sidewall CSW4 in the third direction D3, to the second sidewall CSW2 of the inner spacer ISP.

The fourth length L4 and the fifth length L5 may be greater than the third length L3. The fourth length L4 and the fifth length L5 may be equal to each other. For example, the third length L3 may range from 5.0Å to 15.0Å. Each of the fourth length L4 and the fifth length L5 may range from 10.0Å to 30.0Å (in particular, may range from 12.0Å to 26.0Å).

Referring again to FIGS. 6A and 6B, the first inner gate spacer IGP1 may be spaced apart from the first source/drain pattern SD1 with the inner spacer ISP interposed therebetween. The second inner gate spacer IGP2 may be in direct contact with the second source/drain pattern SD2.

The high-k dielectric layer HK may include the inner high-k dielectric layer IHK and an outer high-k dielectric layer OHK. The inner high-k dielectric layer IHK may be disposed between each of the inner gate insulating layers IIL1 and IIL2 and the first to third inner gate electrodes PO1, PO2 and PO3 of each of the first and second gate electrodes GE1 and GE2. The outer high-k dielectric layer OHK may be disposed between the outer gate electrode PO4 of each of the first and second gate electrodes GE1 and GE2 and each of the outer gate insulating layers OIL1 and OIL2.

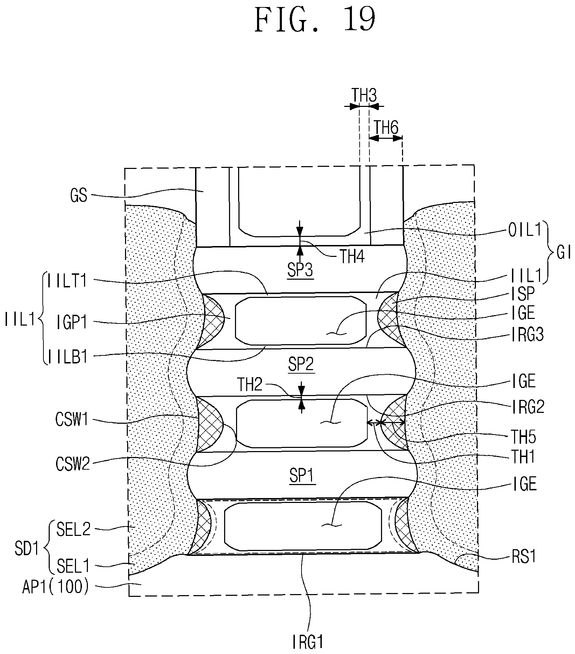

The inner high-k dielectric layer IHK may surround each of the first to third inner gate electrodes PO1, PO2 and PO3 with a uniform thickness. In other words, the inner high-k dielectric layer IHK may be conformally formed in an inner gate space (see IGE of FIG. 19) to be described below. The outer high-k dielectric layer OHK may extend from the bottom surface onto the sidewall of the outer gate electrode PO4. For example, the gate insulating layer GI may be stacked on the high-k dielectric layer HK.

Referring again to FIG. 6C, the inner high-k dielectric layer IHK may include a third sidewall CSW3 in contact with the second inner gate electrode PO2, and the fourth sidewall CSW4 in contact with the first inner gate spacer IGP1. The third sidewall CSW3 and the fourth sidewall CSW4 may have flat surface shapes in the third direction D3 perpendicular to the bottom surface of the substrate 100. In some embodiments, the third sidewall CSW3 and the fourth sidewall CSW4 may have curved surface shapes.

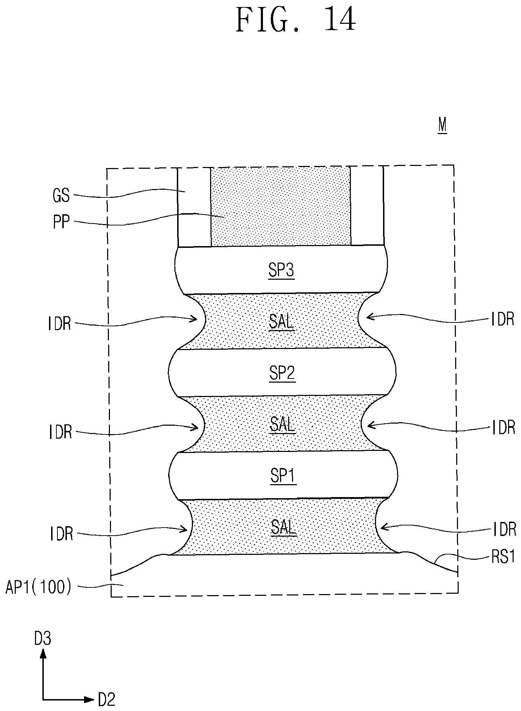

An indent region IDR (see FIG. 14) may be defined between the first source/drain pattern SD1 and each of the first to third inner gate electrodes PO1 to PO3 of the first gate electrode GE1. The indent region IDR (see FIG. 14) may be an empty space extending from the first source/drain pattern SD1 toward a corresponding one of the first to third inner gate electrodes PO1 to PO3. A sidewall of the first inner gate spacer IGP1 may be concave by the indent region IDR (see FIG. 14).

The inner spacer ISP may be provided in each of the indent regions IDR (see FIG. 14). According to the present embodiments, the inner spacer ISP may completely fill the indent region IDR (see FIG. 14). The first sidewall CSW1 of the inner spacer ISP may be in direct contact with the first source/drain pattern SD1. The second sidewall CSW2 of the inner spacer ISP may be in direct contact with the gate insulating layer GI. More particularly, the second sidewall CSW2 may be in direct contact with the first inner gate spacer IGP1 of the first inner gate insulating layer III,1.

The first sidewall CSW1 may be opposite to the second sidewall CSW2 in the second direction D2. The first sidewall CSW1 and the second sidewall CSW2 may be curved surfaces. A curvature of the first sidewall CSW1 may be less than a curvature of the second sidewall CSW2. In some embodiments, the curvature of the first sidewall CSW1 may be substantially equal to the curvature of the second sidewall CSW2.

The inner spacer ISP may include a silicon (Si)-containing insulating material. For example, the inner spacer ISP may include SiOₓ, SiₓN_{y}, SiₓO_{y}C_{z}Nᵥ, or any combination thereof. For example, the inner spacer ISP may include an insulating material different from those of the gate spacer GS and the first inner gate spacer IGP1.

The inner spacer ISP may vertically overlap with the gate spacer GS. More particularly, the gate spacer GS may vertically overlap with a portion of the inner spacer ISP and a portion of the first inner gate spacer IGP1.

Referring again to FIGS. 6A and 6B, the first inner gate spacer IGP1 may have a first thickness TH1. The first thickness TH1 may be defined as the shortest distance between one sidewall of the inner high-k dielectric layer IHK and one sidewall of the inner spacer ISP. The first thickness TH1 may be a distance in the second direction D2.

The first upper insulating layer IILT1 or the first lower insulating layer III,B1 may have a second thickness TH2. The second thickness TH2 may be defined as the shortest distance between the top surface of the inner high-k dielectric layer IHK and the bottom surface of an upper one (e.g., SP2) of the semiconductor patterns adjacent to each other. The second thickness TH2 may be a distance in the third direction D3.

The first outer gate insulating layer OII,1 may have a third thickness TH3 and a fourth thickness TH4. The third thickness TH3 may be defined as the shortest distance between one sidewall of the outer high-k dielectric layer OHK and one sidewall of the gate spacer GS. The third thickness TH3 may be a distance in the second direction D2. The fourth thickness TH4 may be defined as the shortest distance between a bottom surface of the outer high-k dielectric layer OHK and the top surface of the uppermost semiconductor pattern SP3. The fourth thickness TH4 may be a distance in the third direction D3.

The inner spacer ISP may have a fifth thickness TH5. The fifth thickness TH5 may be defined as the shortest distance between one sidewall of the first inner gate spacer IGP1 and one sidewall of the first source/drain pattern SD1. The fifth thickness TH5 may be a distance in the second direction D2.

The gate spacer GS may have a sixth thickness TH6. The sixth thickness TH6 may be defined as the shortest distance between one sidewall of the first outer gate insulating layer OIL1 and one sidewall of the first interlayer insulating layer 110. The sixth thickness TH6 may be a distance in the second direction D2.

The second inner gate spacer IGP2 may have a seventh thickness TH7. The seventh thickness TH7 may be defined as the shortest distance between one sidewall of the inner high-k dielectric layer IHK and one sidewall of the second source/drain pattern SD2. The seventh thickness TH7 may be a distance in the second direction D2.

The second upper insulating layer III,T2 or the second lower insulating layer III,B2 may have an eighth thickness TH8. The eighth thickness TH8 may be defined as the shortest distance between the top surface of the inner high-k dielectric layer IHK and the bottom surface of an upper one (e.g., SP2) of the semiconductor patterns adjacent to each other. The eighth thickness TH8 may be a distance in the third direction D3.

The first thickness TH1 may be greater than the second thickness TH2. The fifth thickness TH5 may be greater than the first thickness TH1. The third thickness TH3 and the fourth thickness TH4 may be greater than the second thickness TH2 and may be less than the first thickness TH1. The third thickness TH3 and the fourth thickness TH4 may be equal to each other. The sixth thickness TH6 may be greater than the fifth thickness TH5. In other words, the width of the gate spacer GS may be greater than the maximum width of the inner spacer ISP. In certain embodiments, a sum of the first thickness TH1 and the fifth thickness TH5 may be greater than the sixth thickness TH6.

The first thickness TH1 may be equal to (or defined as) an average value of the third length L3 of the vertical portion VPO, the fourth length L4 of the first corner portion CPO1 and the fifth length L5 of the second corner portion CPO2. For example, the average value may be a target value for forming the first inner gate spacer IGP1 between the inner spacer ISP and the inner gate electrodes PO1, PO2 and PO3.

The seventh thickness TH7 may be less than a sum of the first thickness TH1 and the fifth thickness TH5. The seventh thickness TH7 may be equal to the first thickness TH1 or may be less than the first thickness TH1. The seventh thickness TH7 may be greater than the eighth thickness TH8. A ratio of the seventh thickness TH7 to the eighth thickness TH8 may range from 1.1 to 1.8 (in particular, may be 1.5).

For example, each of the first thickness TH1 and the seventh thickness TH7 may range from 1.0Å to 15.0Å. Each of the second thickness TH2 and the eighth thickness TH8 may range from 1.0Å to 10.0Å. Each of the third thickness TH3 and the fourth thickness TH4 may range from 1.0Å to 13.0Å. The fifth thickness TH5 may range from 10.0Å to 25.0Å.

According to the embodiments of the inventive concepts, the sum of the thickness of the first inner gate spacer IGP1 and the thickness of the inner spacer ISP may be greater than the thickness of the second inner gate spacer IGP2, and thus a leakage current of the transistor may be effectively reduced. In other words, the three-dimensional field effect transistors according to the inventive concepts may have a double spacer capable of preventing a gate leakage current on the NMOSFET region and may have a single spacer capable of preventing a gate leakage current on the PMOSFET region. Thus, the gate leakage currents of the transistors may be selectively controlled.

In addition, the double spacer may increase the distance between the gate electrode and the first source/drain pattern, and thus a capacitance and the gate leakage current may be effectively reduced. According to the inventive concepts, the thickness of the double spacer may be selectively increased to improve electrical characteristics of the semiconductor device. The single spacer may separate the gate electrode from the second source/drain pattern, and the second source/drain pattern may protrude between the semiconductor patterns. Thus, the second source/drain pattern may be formed without defects. As a result, the reliability and electrical characteristics of the semiconductor device according to the inventive concepts may be improved.

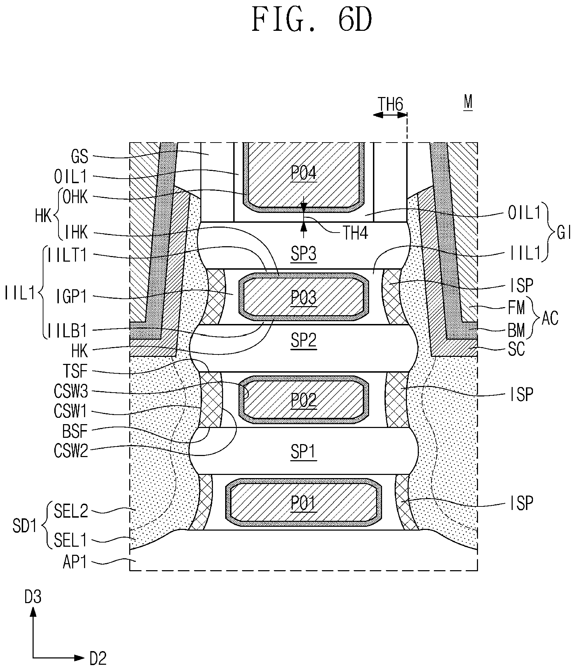

FIG. 6D is an enlarged view illustrating an embodiment of the region 'M' of FIG. 5A. In the present embodiments, the descriptions to the same technical features as mentioned above with reference to FIGS. 1 to 6A will be omitted and differences between the present embodiments and the above embodiments will be mainly described, for the purpose of ease and convenience in explanation.

Referring to FIG. 6D, an inner spacer ISP may be provided in each of indent regions IDR (see FIG. 14). According to the present embodiments, the inner spacer ISP may completely fill the indent region IDR (see FIG. 14). A first sidewall CSW1 of the inner spacer ISP may be in direct contact with the first source/drain pattern SD1. A second sidewall CSW2 of the inner spacer ISP may be in direct contact with the gate insulating layer GI. More particularly, the second sidewall CSW2 may be in direct contact with the first inner gate spacer IGP1 of the first inner gate insulating layer III,1.

The first sidewall CSW1 may be opposite to the second sidewall CSW2 in the second direction D2. The first sidewall CSW1 and the second sidewall CSW2 may have curved surfaces. A curvature of the first sidewall CSW1 may be substantially equal to a curvature of the second sidewall CSW2.

The inner spacer ISP may include a top surface TSF and a bottom surface BSF which are adjacent to the semiconductor patterns SP1 to SP3. The top surface TSF and the bottom surface BSF may be opposite to each other in the third direction D3. For example, the top surface TSF of the inner spacer ISP may be in contact with a portion of the bottom surface of the second semiconductor pattern SP2, and the bottom surface BSF of the inner spacer ISP may be in contact with a portion of the top surface of the first semiconductor pattern SP1.

The inner spacer ISP may vertically overlap with the gate spacer GS. More particularly, the gate spacer GS may vertically overlap with a portion of the inner spacer ISP and a portion of the first inner gate spacer IGP1.

Each of the inner spacers ISP may have a uniform width in the second direction D2. This may be to uniformly at least partially or fully fill an inner gate space to be described below with a bulk oxide layer. Thus, a width of the first inner gate spacer IGP1 in the second direction D2 may be uniform. Since the inner gate spaces are secured, edge portions of the inner gate spaces may be rounded to stably form the inner gate electrodes PO1 to PO3. In other words, the work function of each of the inner gate electrodes PO1 to PO3 may be uniform. Thus, electrical characteristics of the semiconductor device according to the embodiments of the inventive concepts may be improved.

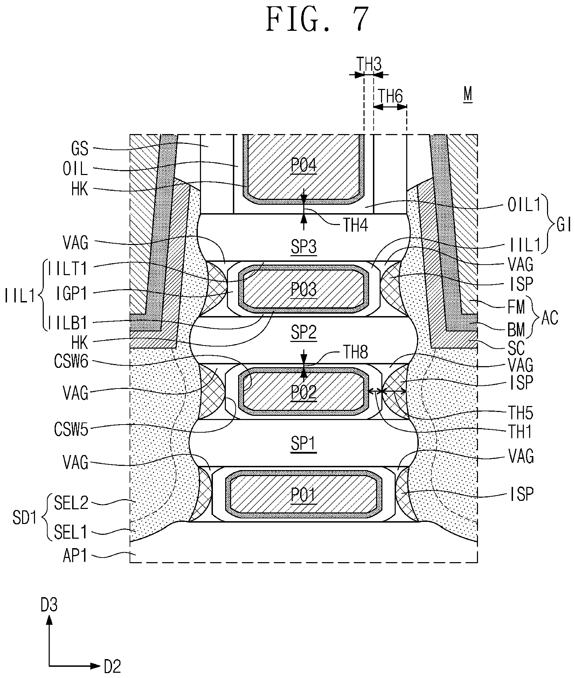

FIG. 7 is an enlarged view illustrating an embodiment of the region 'M' of FIG. 5A. In the present embodiments, the descriptions to the same technical features as mentioned above with reference to FIGS. 1 to 6A and 6D will be omitted and differences between the present embodiments and the above embodiments will be mainly described, for the purpose of ease and convenience in explanation.

Referring to FIG. 7, an air gap VAG may be defined between the first inner gate insulating layer IIL1 and the inner spacer ISP. The air gap VAG may be surrounded by the inner spacer ISP, the first inner gate insulating layer IIL1 and one of the first to third semiconductor patterns SP1 to SP3.

The air gaps VAG may be provided on a first corner portion CPO1 and a second corner portion CPO2 of a first inner gate spacer IGP1. For example, the air gaps VAG may be defined between the first corner portion CPO1 and the inner spacer ISP and between the second corner portion CPO2 and the inner spacer ISP, respectively. In some embodiments, four air gaps VAG may be provided in an inner region IRG to be described below. The four air gaps VAG may be adjacent to four corners of an inner gate space IGE to be described below, respectively.

According to a manufacturing method to be described below, sacrificial layers SAL exposed through an outer region ORG formed by selectively removing a sacrificial pattern PP may be removed. The sacrificial layers SAL may be selectively removed to form first to third inner regions IRG1 to IRG3. The first inner gate insulating layer IIL1 may be formed in the first to third inner regions IRG1 to IRG3.

A space, adjacent to the inner spacer ISP, of a space in each of the first to third inner regions IRG1 to IRG3 may be narrower than another space. In other words, the sidewalls of the inner spacer ISP may be formed as curved surfaces, and thus the space adjacent to the inner spacer ISP may have a tapered shape.

Thus, when a bulk oxide layer BOX is deposited in the first to third inner regions IRG1 to IRG3, the space adjacent to the inner spacer ISP may not be filled. The space not filled may be defined as the air gap VAG according to the embodiments of the inventive concepts.

Even though not shown in the drawings, an optimized deposition process may be performed to form the bulk oxide layer BOX in the first to third inner regions IRG1 to IRG3. In other words, the bulk oxide layer BOX may be deposited without an empty space. In this case, the air gap VAG may not be formed between the inner spacer ISP and the first inner gate insulating layer III,1. The semiconductor device in which the air gap VAG is not formed may correspond to the embodiments of FIG. 6A.

Referring again to FIG. 7, a topmost surface of the inner spacer ISP may be located at the same level as a topmost surface of the first upper insulating layer IILT1 in the third direction D3. In other words, the topmost surface of the inner spacer ISP and the topmost surface of the first upper insulating layer IILT1 may be in contact with the bottom surface of the third semiconductor pattern SP3. A bottommost surface of the inner spacer ISP may be located at the same level as a bottommost surface of the first lower insulating layer IILB1 in the third direction D3. In other words, the bottommost surface of the inner spacer ISP and the bottommost surface of the first lower insulating layer IILB1 may be in contact with the top surface of the second semiconductor pattern SP2.

Even though not shown in the drawings, in certain embodiments, the topmost surface of the inner spacer ISP may be located at a lower level than the topmost surface of the first upper insulating layer IILT1 in the third direction D3. The bottommost surface of the inner spacer ISP may be located at a higher level than the bottommost surface of the first lower insulating layer IILB1 in the third direction D3.

This may be because a selective etching process is insufficiently performed when the indent region IDR (see FIG. 14) is formed in a manufacturing method to be described below. For example, the sacrificial layer SAL (see FIG. 14) may be partially etched. Thus, portions, adjacent to the first to third semiconductor patterns SP1 to SP3 (see FIG. 14), of a sidewall of the sacrificial layer SAL (see FIG. 14) may be vertically flat. Another portion of the sidewall of the sacrificial layer SAL (see FIG. 14) except the adjacent portions may be concavely formed. As a result, the topmost surface of the inner spacer ISP may be located at a lower level than the topmost surface of the first upper insulating layer IILT1 in the third direction D3, and the bottommost surface of the inner spacer ISP may be located at a higher level than the bottommost surface of the first lower insulating layer IILB1 in the third direction D3.

According to the present embodiments, the air gap VAG may be provided at a corner portion of the inner spacer ISP to reduce a capacitance between the first source/drain pattern SD1 and each of the inner gate electrodes PO1, PO2 and PO3. As a result, electrical characteristics of the semiconductor device according to the inventive concepts may be improved.

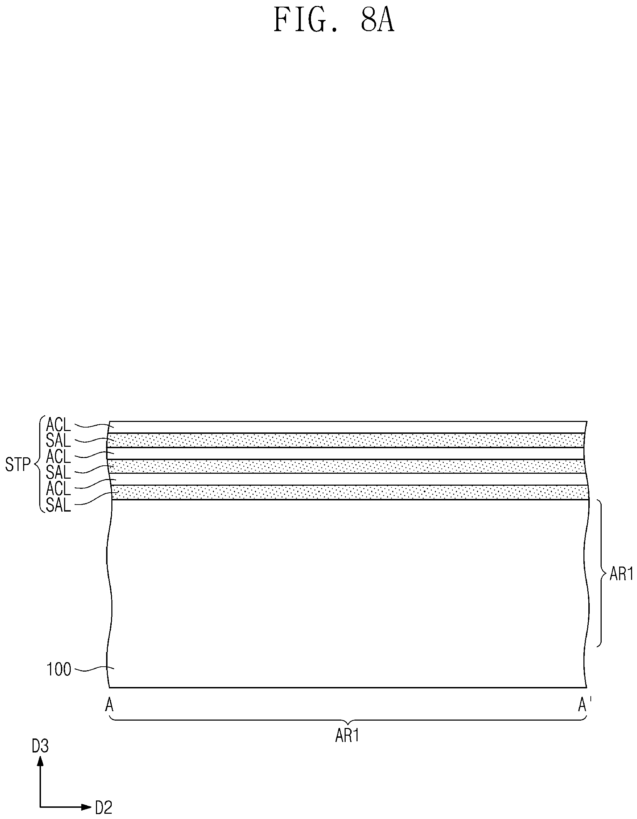

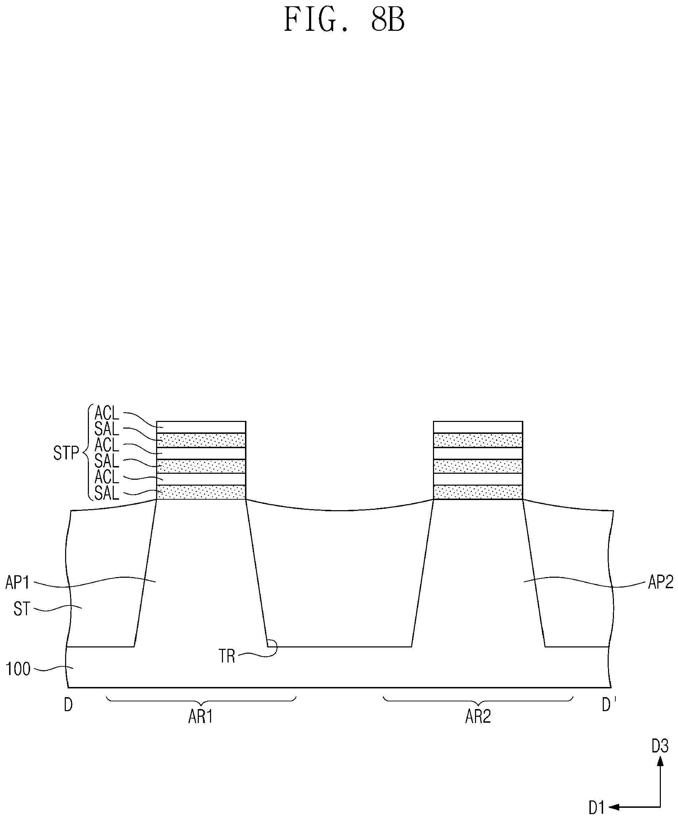

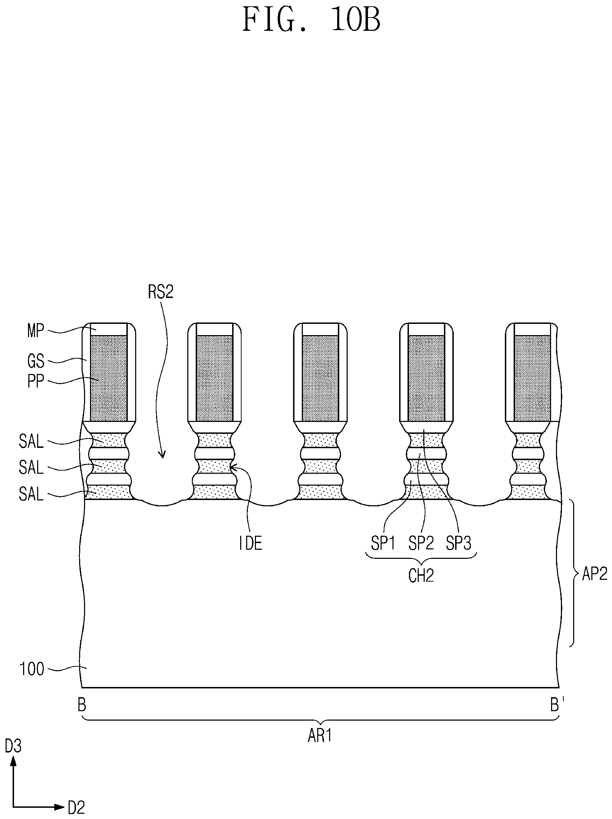

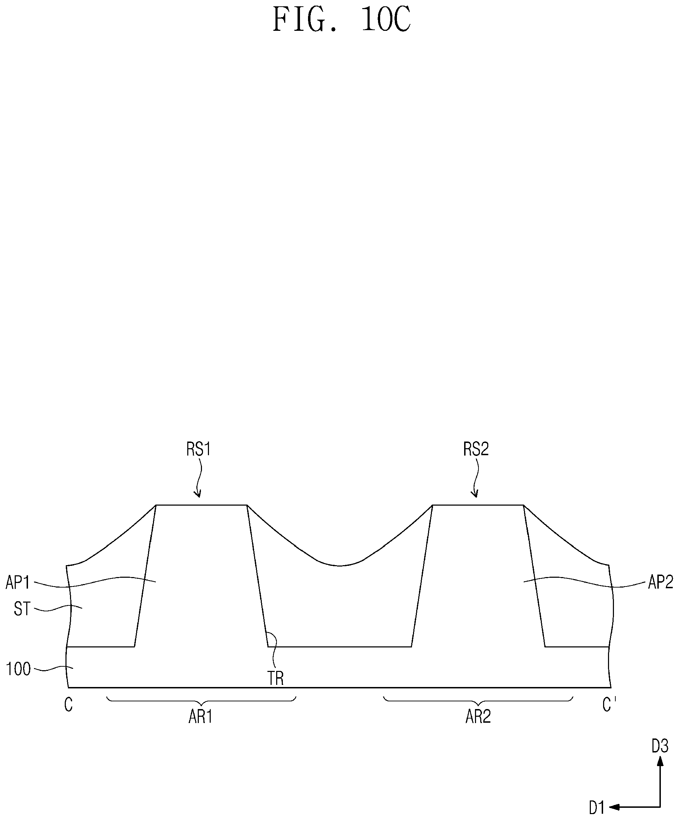

FIGS. 8A to 13D are cross-sectional views illustrating a method of manufacturing a semiconductor device according to some embodiments of the inventive concepts. More particularly, FIGS. 8A, 9A, 10A, 11A, 12A and 13A are cross-sectional views corresponding to the line A-A' of FIG. 4. FIGS. 10B, 11B, 12B and 13B are cross-sectional views corresponding to the line B-B' of FIG. 4. FIGS. 10C, 11C, 12C and 13C are cross-sectional views corresponding to the line C-C' of FIG. 4. FIGS. 8B, 9B, 10D, 12D and 13D are cross-sectional views corresponding to the line D-D' of FIG. 4.

Referring to FIGS. 8A and 8B, a substrate 100 including first and second active regions AR1 and AR2 may be provided. Active layers ACL and sacrificial layers SAL may be formed to be alternately stacked on the substrate 100. The active layers ACL may include one of silicon (Si), germanium (Ge) and/or silicon-germanium (SiGe), and the sacrificial layers SAL may include another of silicon (Si), germanium (Ge) and/or silicon-germanium (SiGe).

The sacrificial layer SAL may include a material having an etch selectivity with respect to the active layer ACL. For example, the active layers ACL may include silicon (Si), and the sacrificial layers SAL may include silicon-germanium (SiGe). A concentration of germanium (Ge) of each of the sacrificial layers SAL may range from 10 at% to 30 at%.

Mask patterns may be formed on the first and second active regions AR1 and AR2 of the substrate 100, respectively. Each of the mask patterns may have a line shape or bar shape extending in the second direction D2.

A patterning process may be performed using the mask patterns as etch masks to form a trench TR defining a first active pattern AP1 and a second active pattern AP2. The first active pattern AP1 may be formed on the first active region AR1. The second active pattern AP2 may be formed on the second active region AR2.

A stack pattern STP may be formed on each of the first and second active patterns AP 1 and AP2. The stack pattern STP may include the active layers ACL and the sacrificial layers SAL, which are alternately stacked. The stack patterns STP may be formed together with the first and second active patterns AP1 and AP2 in the patterning process.

A device isolation layer ST filling the trench TR may be formed. For example, an insulating layer covering, on, or overlapping the first and second active patterns AP1 and AP2 and the stack patterns STP may be formed on an entire top surface of the substrate 100. The insulating layer may be recessed until the stack patterns STP are exposed, thereby forming the device isolation layer ST.

The device isolation layer ST may include an insulating material (e.g., silicon oxide). The stack patterns STP may be exposed above the device isolation layer ST. In other words, the stack patterns STP may vertically protrude above the device isolation layer ST.

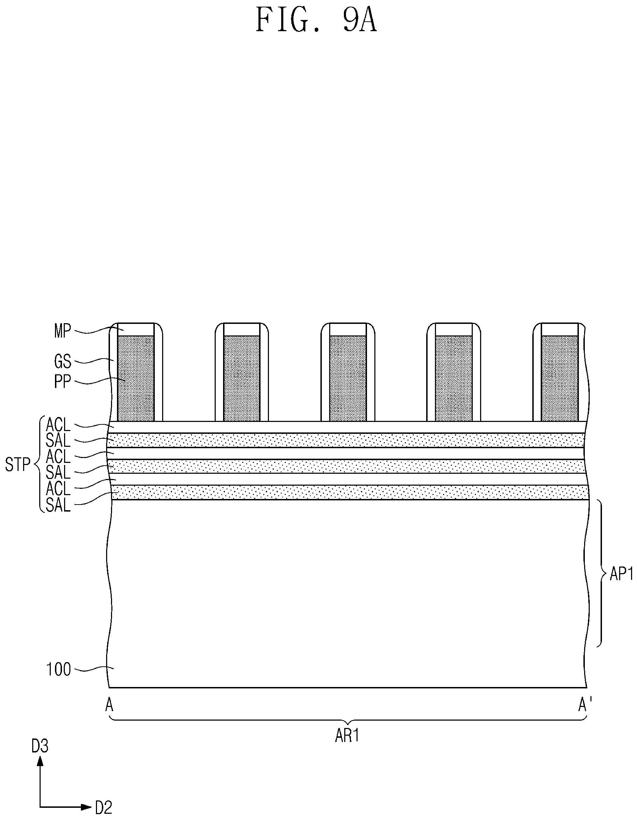

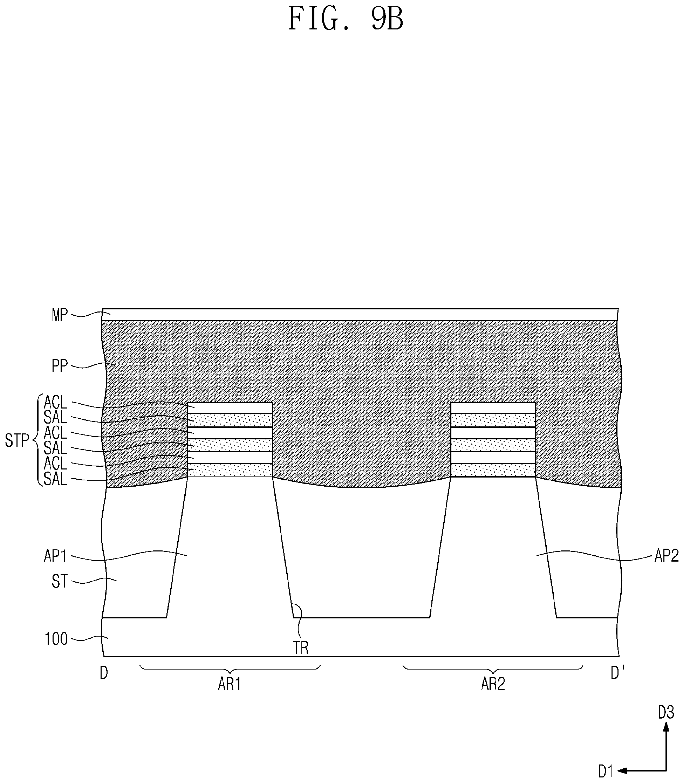

Referring to FIGS. 9A and 9B, sacrificial patterns PP intersecting the stack patterns STP may be formed on the substrate 100. Each of the sacrificial patterns PP may be formed to have a line shape or bar shape extending in the first direction D1. The sacrificial patterns PP may be arranged at a first pitch in the second direction D2.

For example, the formation of the sacrificial patterns PP may include forming a sacrificial layer on an entire top surface of the substrate 100, forming hard mask patterns MP on the sacrificial layer, and patterning the sacrificial layer using the hard mask patterns MP as etch masks. The sacrificial layer may include poly-silicon.

A pair of gate spacers GS may be formed on both sidewalls of each of the sacrificial patterns PP, respectively. The formation of the gate spacers GS may include conformally forming a gate spacer layer on an entire top surface of the substrate 100, and anisotropically etching the gate spacer layer. In some embodiments, the gate spacer GS may be formed of a multi-layer including at least two layers.

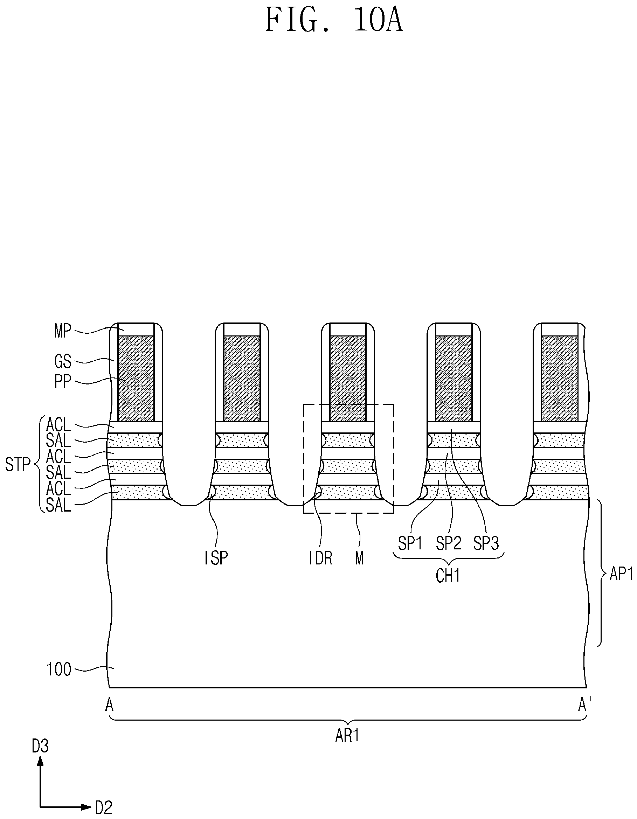

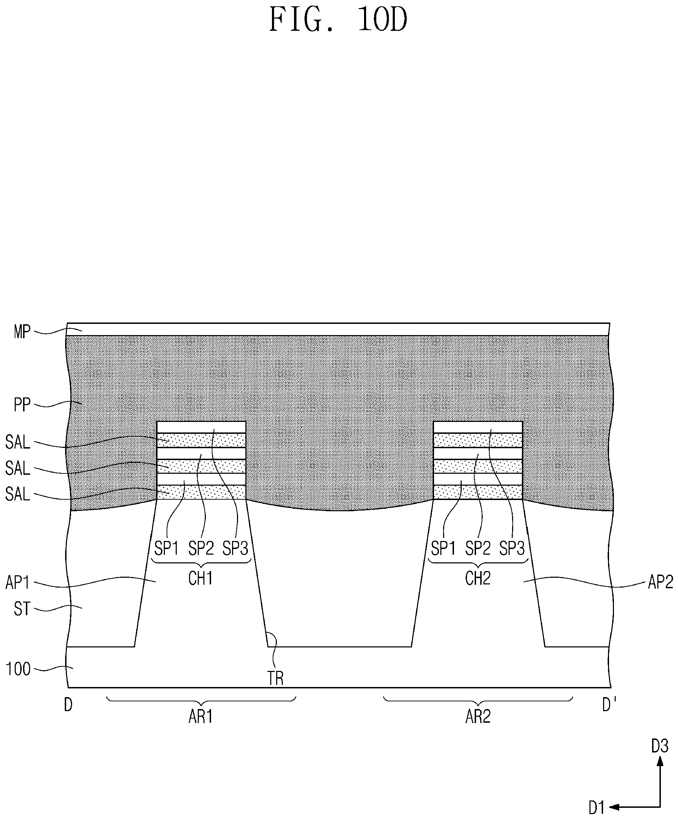

Referring to FIGS. 10A, 10B, 10C, and 10D, first recesses RS1 may be formed in the stack pattern STP on the first active pattern AP1. Second recesses RS2 may be formed in the stack pattern STP on the second active pattern AP2. The device isolation layer ST at both sides of each of the first and second active patterns AP1 and AP2 may be further recessed during the formation of the first and second recesses RS1 and RS2 (see FIG. 10C).

For example, the stack pattern STP on the first active pattern AP1 may be etched using the hard mask patterns MP and the gate spacers GS as etch masks to form the first recesses RS1. The first recess RS1 may be formed between a pair of the sacrificial patterns PP.

In some embodiments of the inventive concepts, a selective etching process may be additionally performed on the sacrificial layers SAL exposed by the second recess RS2. Each of the sacrificial layers SAL may be indented by the selective etching process to form an indent region IDE. The indent regions IDE may be formed on the second active pattern AP2. The second recess RS2 may have a wave-shaped inner sidewall by the indent regions IDE.

First to third semiconductor patterns SP1, SP2 and SP3 sequentially stacked between the first recesses RS1 adjacent to each other may be formed from the active layers ACL, respectively. The first to third semiconductor patterns SP1, SP2 and SP3 between the first recesses RS1 adjacent to each other may constitute a first channel pattern CH1.

First to third semiconductor patterns SP1, SP2 and SP3 sequentially stacked between the second recesses RS2 adjacent to each other may be formed from the active layers ACL, respectively. The first to third semiconductor patterns SP1, SP2 and SP3 between the second recesses RS2 adjacent to each other may constitute a second channel pattern CH2.

FIGS. 14 to 16 are enlarged views illustrating a method of forming a region 'M' of FIG. 10A. Referring to FIG. 14, the first recess RS1 may be formed between the sacrificial patterns PP adjacent to each other, as described above. A width of the first recess RS1 in the second direction D2 may become less toward the substrate 100.

The sacrificial layers SAL may be exposed by the first recess RS1. An etching process may be performed on the exposed sacrificial layers SAL. The etching process may include a wet etching process of selectively removing silicon-germanium. Each of the sacrificial layers SAL may be indented by the etching process to form an indent region IDR. A sidewall of the sacrificial layer SAL may be concave by the indent region IDR. A width of the sacrificial layer SAL in the second direction D2 may be less than a width of each of the first to third semiconductor patterns SP1 to SP3 in the second direction D2.

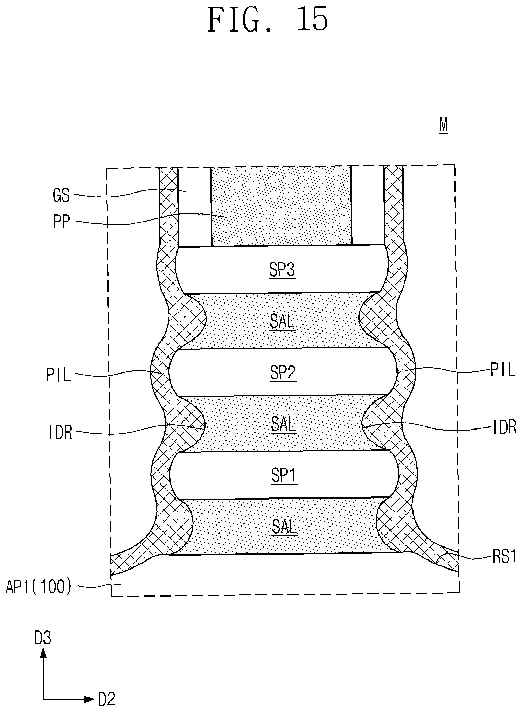

Referring to FIG. 15, a bulk insulating layer PIL filling the indent regions IDR may be formed in the first recess RS1. More particularly, the bulk insulating layer PIL may extend from an inner surface of the first recess RS1 onto a sidewall of the gate spacer GS. For example, the bulk insulating layer PIL may include SiOₓ, SiₓN_{y}, SiₓO_{y}C_{z}Nᵥ, or any combination thereof. The bulk insulating layer PIL may be deposited by performing a chemical vapor deposition (CVD) process, a physical vapor deposition (PVD) process or an atomic layer deposition (ALD) process. The bulk insulating layer PIL formed on the sidewalls of the sacrificial layers SAL may be thicker than the bulk insulating layer PIL formed on sidewalls of the first to third semiconductor patterns SP1 to SP3 and the sidewall of the gate spacer GS.

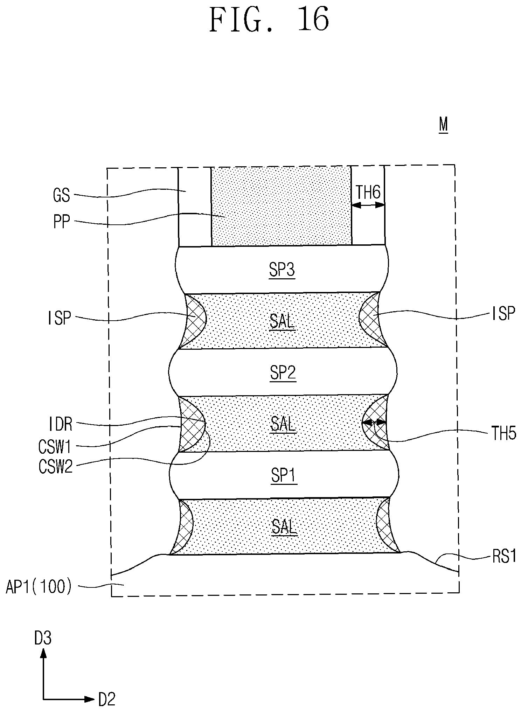

Referring to FIG. 16, an inner spacer ISP may be formed to fill the indent region IDR. For example, the formation of the inner spacer ISP may include wet-etching the bulk insulating layer PIL to expose the sidewalls of the first to third semiconductor patterns SP1, SP2 and SP3. Thus, the bulk insulating layer PIL may remain in only the indent region IDR so as to be formed into the inner spacer ISP.

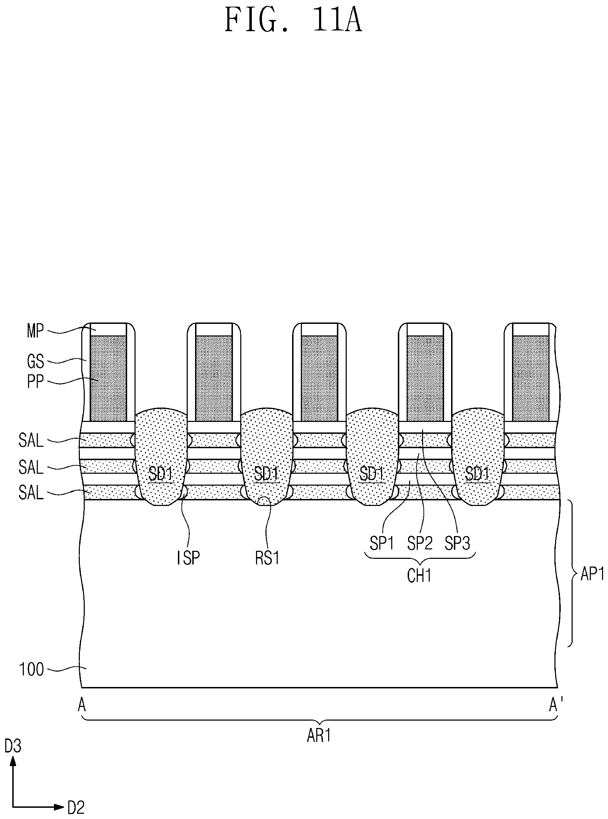

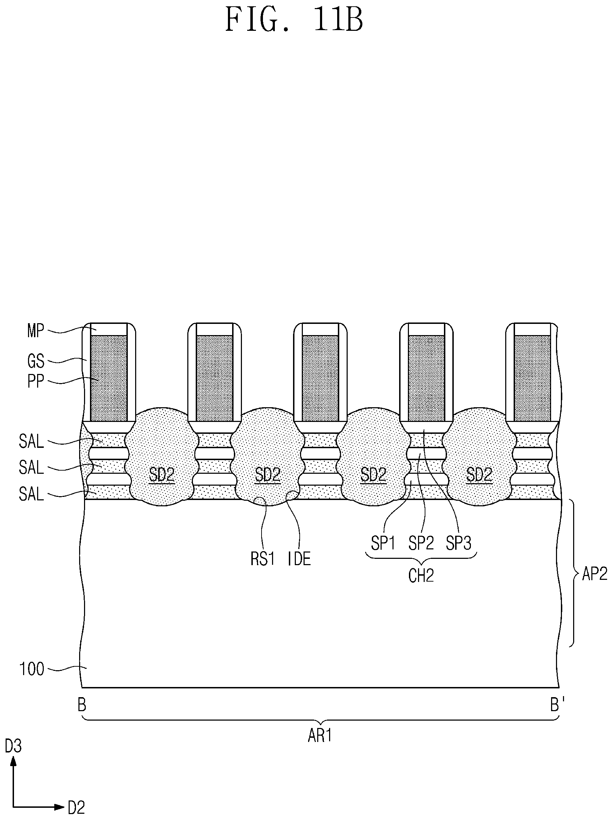

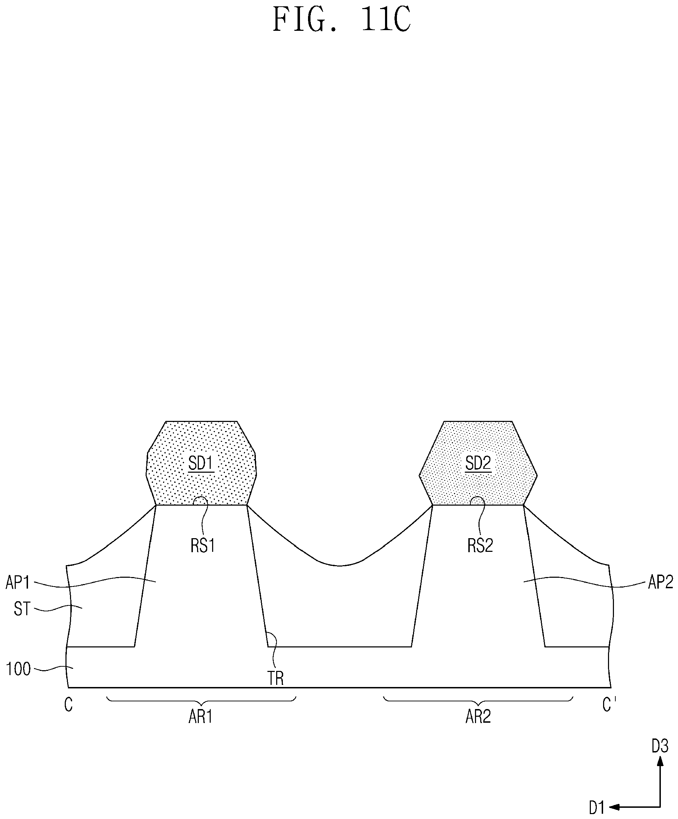

Referring to FIGS. 11A, 11B, and 11C, first source/drain patterns SD1 may be formed in the first recesses RS1, respectively. For example, a SEG process using the inner surface of the first recess RS1 as a seed layer may be performed to form an epitaxial layer filling the first recess RS1. The epitaxial layer may be grown using the first to third semiconductor patterns SP1, SP2 and SP3 and the substrate 100, exposed by the first recess RS1, as a seed. For example, the SEG process may include a chemical vapor deposition (CVD) process or a molecular beam epitaxy (MBE) process.

In some embodiments of the inventive concepts, the first source/drain pattern SD1 may include the same semiconductor element (e.g., Si) as the substrate 100. Dopants (e.g., phosphorus, arsenic or antimony) allowing the first source/drain pattern SD1 to have an n-type may be injected in-situ during the formation of the first source/drain pattern SD1. In some embodiments, after the formation of the first source/drain pattern SD1, the dopants may be injected or implanted into the first source/drain pattern SD1.

Second source/drain patterns SD2 may be formed in the second recesses RS2, respectively. For example, the second source/drain pattern SD2 may be formed by performing a SEG process using an inner surface of the second recess RS2 as a seed layer.

In some embodiments of the inventive concepts, the second source/drain pattern SD2 may include a semiconductor element (e.g., SiGe) having a lattice constant greater than a lattice constant of the semiconductor element of the substrate 100. Dopants (e.g., boron, gallium or indium) allowing the second source/drain pattern SD2 to have a p-type may be injected in-situ during the formation of the second source/drain pattern SD2. In some embodiments, after the formation of the second source/drain pattern SD2, the dopants may be injected or implanted into the second source/drain pattern SD2.

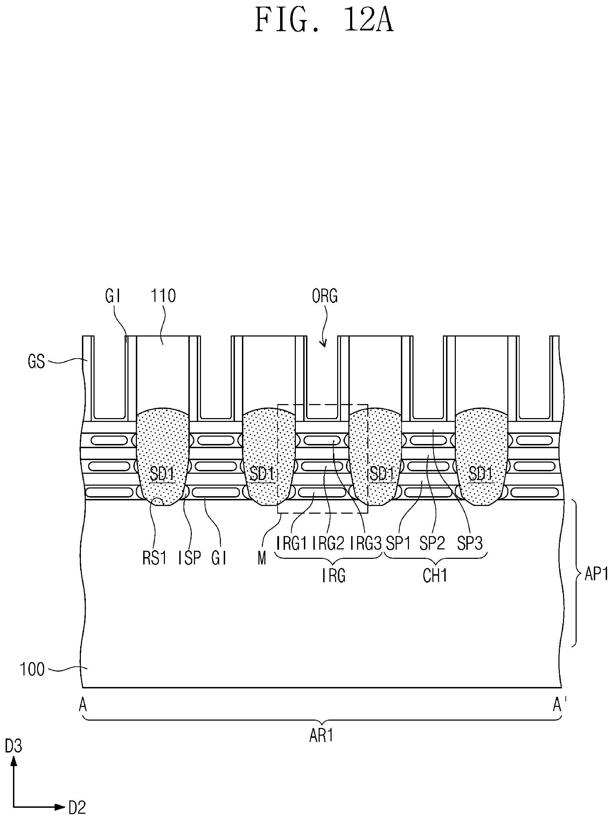

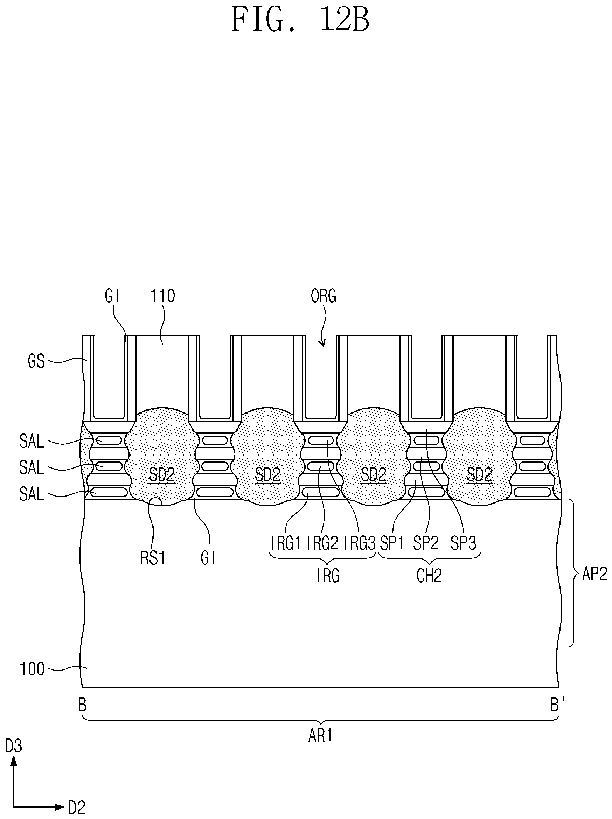

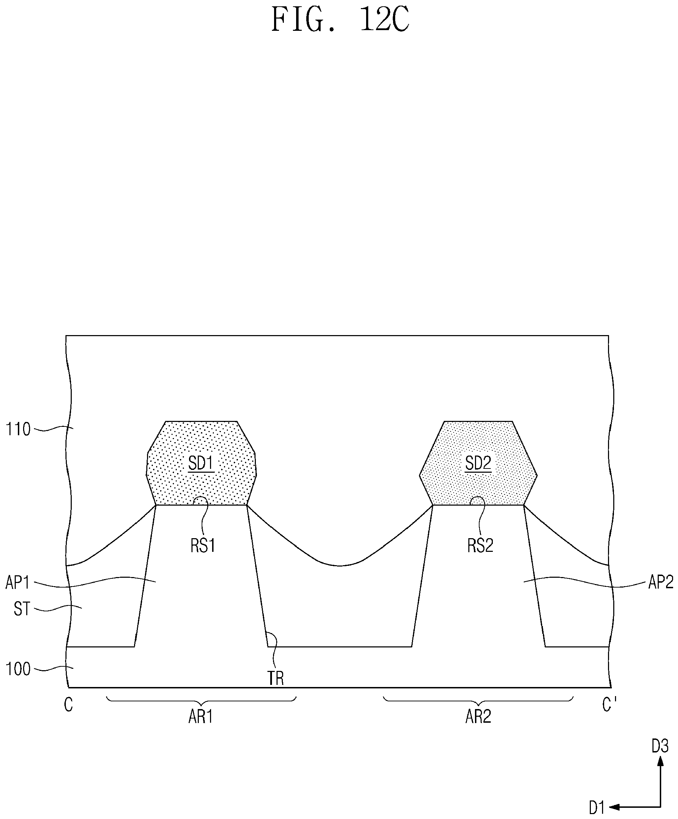

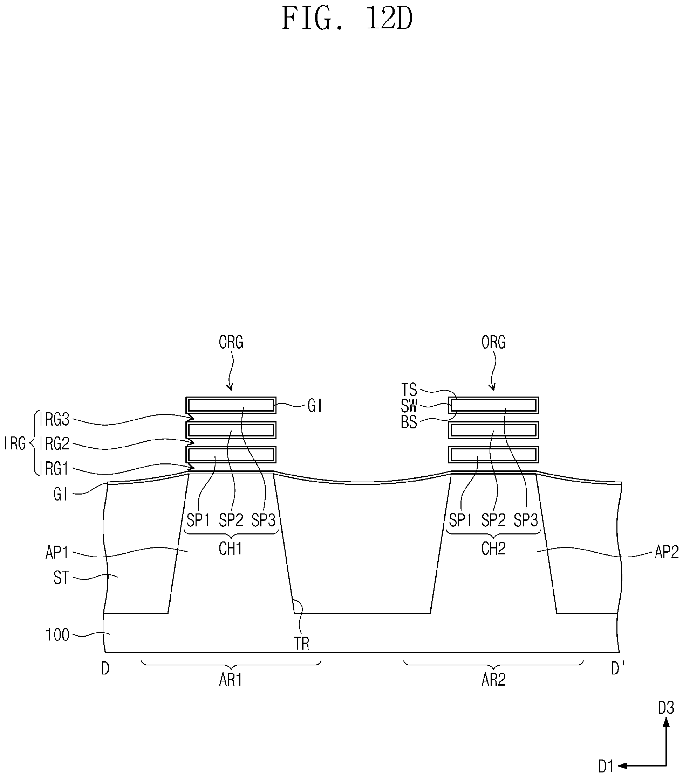

Referring to FIGS. 12A, 12B, 12C, and 12D, a first interlayer insulating layer 110 may be formed to cover or overlap the first and second source/drain patterns SD1 and SD2, the hard mask patterns MP, and the gate spacers GS. For example, the first interlayer insulating layer 110 may include a silicon oxide layer.

The first interlayer insulating layer 110 may be planarized to expose top surfaces of the sacrificial patterns PP. The planarization of the first interlayer insulating layer 110 may be performed using an etch-back process or a chemical mechanical polishing (CMP) process. The hard mask patterns MP may be completely removed during the planarization process. As a result, a top surface of the first interlayer insulating layer 110 may be substantially coplanar with the top surfaces of the sacrificial patterns PP and top surfaces of the gate spacers GS.

The exposed sacrificial patterns PP may be selectively removed. An outer region ORG exposing the first and second channel patterns CH1 and CH2 may be formed by the removal of the sacrificial pattern PP (see FIG. 12D). The removal of the sacrificial patterns PP may include performing a wet etching process using an etching solution capable of selectively etching poly-silicon.

The sacrificial layers SAL exposed through the outer region ORG may be selectively removed to form inner regions IRG (see FIG. 12D). For example, an etching process of selectively etching the sacrificial layers SAL may be performed to remove the sacrificial layers SAL while leaving the first to third semiconductor patterns SP1, SP2 and SP3. The etching process may have a high etch rate with respect to silicon-germanium having a relatively high germanium concentration. For example, the etching process may have a high etch rate with respect to silicon-germanium having a germanium concentration greater than 10 at%.

The sacrificial layers SAL on the first and second active regions AR1 and AR2 may be removed during the etching process. The etching process may be a wet etching process. An etching material used in the etching process may quickly remove the sacrificial layer SAL having a relatively high germanium concentration.

Referring again to FIG. 12D, since the sacrificial layers SAL are selectively removed, the first to third semiconductor patterns SP1, SP2 and SP3 stacked sequentially may remain on each of the first and second active patterns AP1 and AP2. First to third inner regions IRG1, IRG2 and IRG3 may be formed by the removal of the sacrificial layers SAL. More particularly, the first inner region IRG1 may be formed between the active pattern AP1 or AP2 and the first semiconductor pattern SP1, the second inner region IRG2 may be formed between the first semiconductor pattern SP1 and the second semiconductor pattern SP2, and the third inner region IRG3 may be formed between the second semiconductor pattern SP2 and the third semiconductor pattern SP3.

Referring again to FIGS. 12A to 12D, a gate insulating layer GI may be formed on the exposed first to third semiconductor patterns SP1, SP2 and SP3. The gate insulating layer GI may be formed to surround each of the first to third semiconductor patterns SP1, SP2 and SP3. The gate insulating layer GI may be formed in each of the first to third inner regions IRG1, IRG2 and IRG3. The gate insulating layer GI may be formed in the outer region ORG.

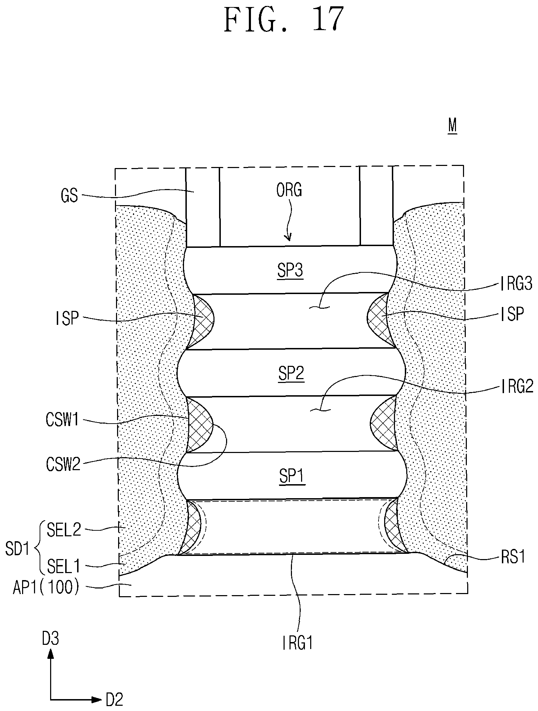

FIGS. 17 to 19 are enlarged views illustrating a method of forming a region 'M' of FIG. 12A. Referring to FIG. 17, the sacrificial pattern PP may be selectively removed to form the outer region ORG, as described above. The sacrificial layers SAL exposed through the outer region ORG may be selectively removed to form the first to third inner regions IRG1 to IRG3. Each of the first to third inner regions IRG1 to IRG3 may be located between a pair of the first source/drain patterns SD1. More particularly, each of the first to third inner regions IRG1 to IRG3 may be located between a pair of the inner spacers ISP.

Representatively, the second inner region IRG2 may expose a second sidewall CSW2 of the inner spacer ISP. The second inner region IRG2 may expose a top surface of the first semiconductor pattern SP1 and a bottom surface of the second semiconductor pattern SP2.

In some embodiments of the inventive concepts, the second sidewall CSW2 of the inner spacer ISP may have a convex profile. A length (or width) of each of the inner regions IRG1 to IRG3 in the second direction D2 may decrease and then increase as a height in the third direction D3 increases. A first side of the first inner region IRG1 may be concave due to the second sidewall CSW2.

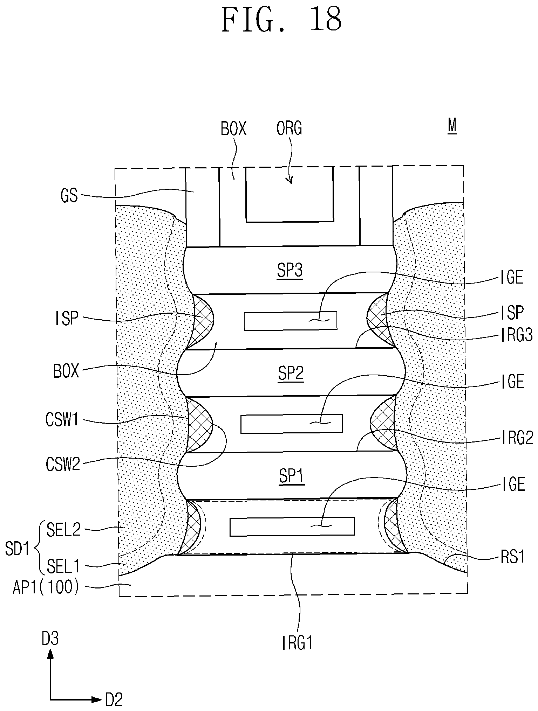

Referring to FIG. 18, a first process may be performed on the first to third inner regions IRG1 to IRG3 and the outer region ORG. The first process may include conformally depositing a bulk oxide layer BOX. The bulk oxide layer BOX may be formed using a deposition process such as an ALD process or a CVD process. The bulk oxide layer BOX may not completely fill the inner regions IRG1 to IRG3 but may partially fill the inner regions IRG1 to IRG3. Thus, an inner gate space IGE surrounded by the bulk oxide layer BOX may be defined in each of the inner regions IRG1 to IRG3. For example, the bulk oxide layer BOX may include a silicon oxide layer, or a silicon oxynitride layer. For example, the bulk oxide layer BOX may include SiOₓ, SiₓO_{y}C_{z}Nᵥ, or any combination thereof.

Referring to FIG. 19, a second process may be performed on the first to third inner regions IRG1 to IRG3 and the outer region ORG. The second process may include partially and selectively etching the bulk oxide layer BOX. The second process may include a wet etching process using an etching solution capable of selectively etching the bulk oxide layer BOX. More particularly, an etching material may be provided through the inner gate space IGE to etch the bulk oxide layer BOX.

After the etching process, the bulk oxide layer BOX may remain on the second sidewall CSW2 of the inner spacer ISP. In particular, a relatively large amount of the bulk oxide layer BOX may remain on the second sidewall CSW2 of the inner spacer ISP. In other words, the etched bulk oxide layer BOX may thickly remain on the sidewall of the inner spacer ISP and may thinly remain on the top and bottom surfaces of the semiconductor patterns SP1 to SP3 adjacent thereto. The etched bulk oxide layer BOX may be formed into a first inner gate insulating layer III,1 and a first outer gate insulating layer OIL1. The first inner gate insulating layer III,1 may provide an inner gate space IGE expanded as compared with the inner gate space IGE of FIG. 14.

Thereafter, a high-k dielectric layer HK (see FIG. 6A) may be formed in the outer region ORG and the first to third inner regions IRG1 to IRG3. The high-k dielectric layer HK of FIG. 6A may be formed in the inner gate space IGE. In some embodiments of the inventive concepts, the high-k dielectric layer HK of FIG. 6A may be conformally formed. In other words, a thickness of the high-k dielectric layer HK in a horizontal direction may be substantially equal to a thickness of the high-k dielectric layer HK in a vertical direction.

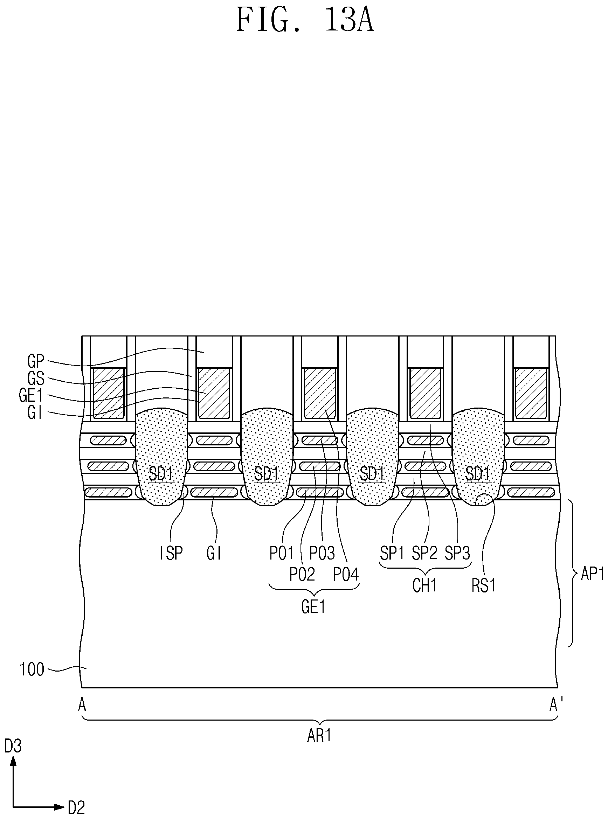

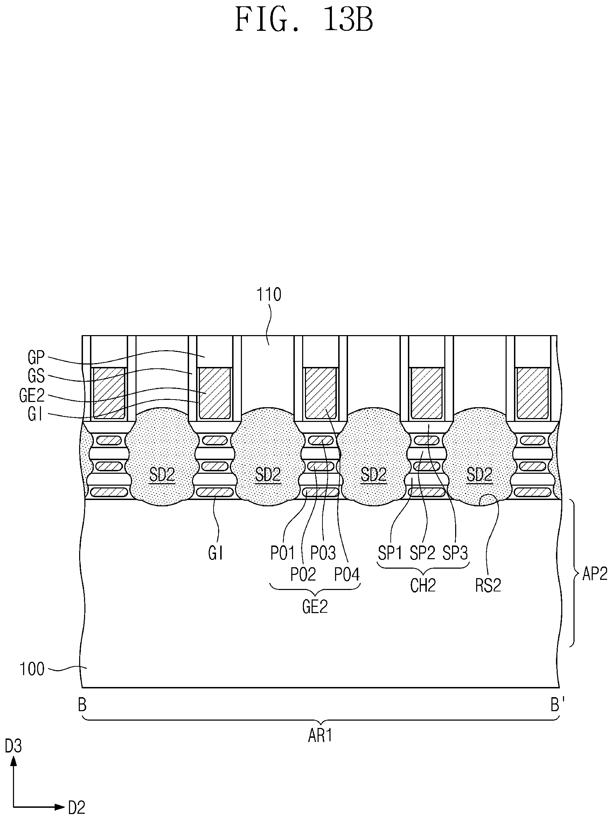

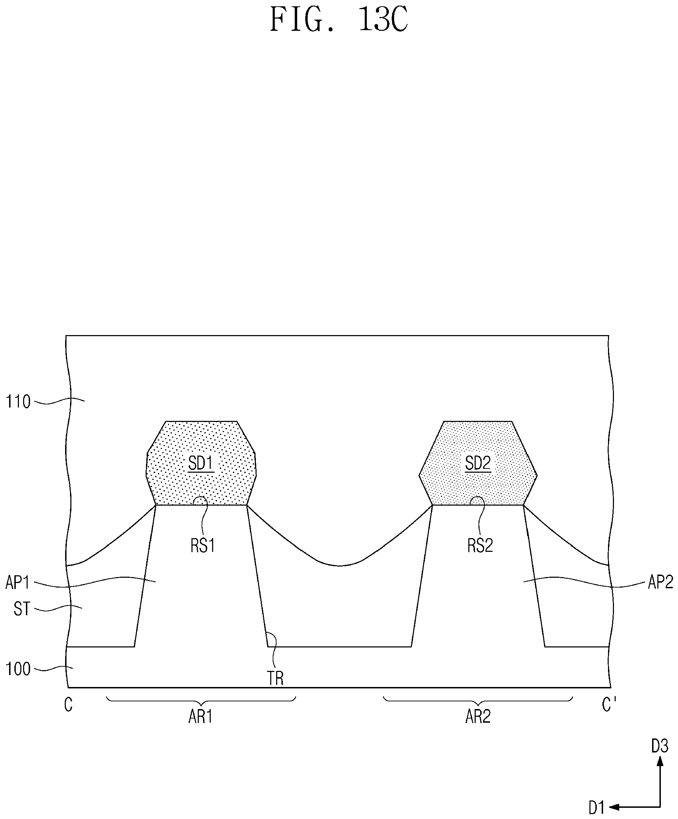

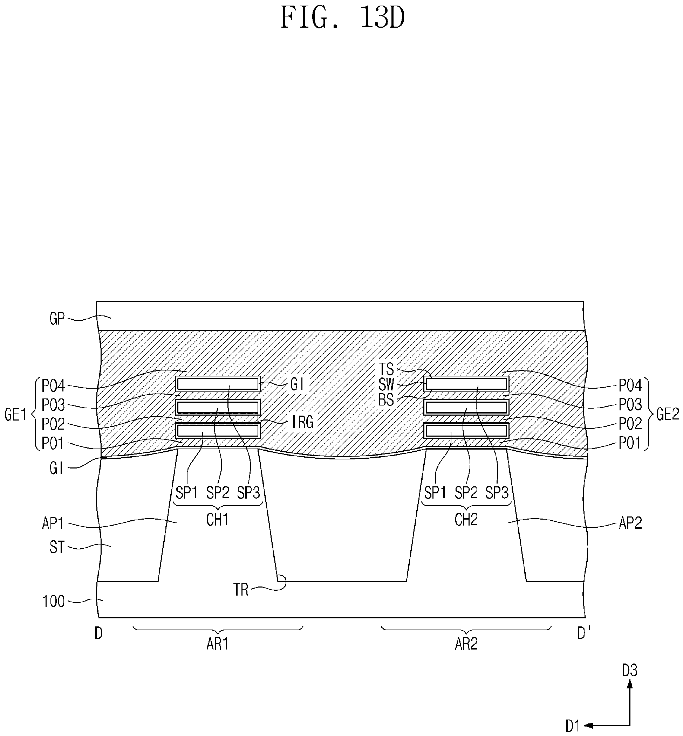

Referring to FIGS. 13A to 13D, a gate electrode GE including first and second gate electrodes GE1 and GE2 may be formed on the gate insulating layer GI. More particularly, the gate electrode GE may be formed on the high-k dielectric layer HK (see FIG. 6A). In other words, the high-k dielectric layer HK may be formed on the gate insulating layer GI, and the gate electrodes GE1 and GE2 may be formed on the high-k dielectric layer HK. Each of the gate electrodes GE1 and GE2 may include first to third inner gate electrodes PO1, PO2 and PO3 formed in the first to third inner regions IRG1, IRG2 and IRG3, respectively, and an outer gate electrode PO4 formed in the outer region ORG. The gate electrode GE may be recessed to reduce its height. A gate capping pattern GP may be formed on the recessed gate electrode GE.

Referring again to FIGS. 5A, 5B, 5C, and 5D, a second interlayer insulating layer 120 may be formed on the first interlayer insulating layer 110. The second interlayer insulating layer 120 may include a silicon oxide layer. Active contacts AC may be formed to penetrate the second interlayer insulating layer 120 and the first interlayer insulating layer 110, and the active contacts AC may be electrically connected to the first and second source/drain patterns SD1 and SD2. A gate contact GC may be formed to penetrate the second interlayer insulating layer 120 and the gate capping pattern GP, and the gate contact GC may be electrically connected to the gate electrode GE.

The formation of each of the active contact AC and the gate contact GC may include forming a barrier pattern BM, and forming a conductive pattern FM on the barrier pattern BM. The barrier pattern BM may be conformally formed and may include a metal layer/a metal nitride layer. The conductive pattern FM may include a low-resistance metal.

Isolation structures DB may be formed at a first boundary BD1 and a second boundary BD2 of the single height cell SHC, respectively. The isolation structure DB may penetrate the second interlayer insulating layer 120 and the gate electrode GE and may extend into the active pattern AP1 or AP2. The isolation structure DB may include an insulating material such as silicon oxide or silicon nitride.

A third interlayer insulating layer 130 may be formed on the active contacts AC and the gate contacts GC. A first metal layer M1 may be formed in the third interlayer insulating layer 130. A fourth interlayer insulating layer 140 may be formed on the third interlayer insulating layer 130. A second metal layer M2 may be formed in the fourth interlayer insulating layer 140.

In the three-dimensional field effect transistor according to the inventive concepts, the inner gate insulating layer may include the inner gate spacer capable of preventing a leakage current of a gate. A thickness of a side portion of the inner gate insulating layer may be selectively increased and thicknesses of a horizontal portion and a corner portion of the inner gate insulating layer may be minimized, thereby securing the sufficient inner gate space. Thus, the inner gate electrode may stably fill the inner gate space. In addition, an edge portion of the inner gate electrode may be rounded to stably fill the inner gate space with the inner gate electrode. Thus, the work function of the inner gate electrode may be uniform. As a result, the electrical characteristics of the semiconductor device according to the inventive concepts may be improved.

The three-dimensional field effect transistors according to the inventive concepts may have the double spacer capable of preventing a gate leakage current on the NMOSFET region and may have the single spacer capable of preventing a gate leakage current on the PMOSFET region. The double spacer may reduce a capacitance and a gate leakage current between the gate electrode and the first source/drain pattern. The single spacer may form the second source/drain pattern without defects. As a result, the reliability and electrical characteristics of the semiconductor device according to the inventive concepts may be improved.

While the embodiments of the inventive concepts have been particularly shown and described, it will be understood by one of ordinary skill in the art that variations in form and detail may be made therein without departing from the spirit and scope of the attached claims.

## Claims

1. A semiconductor device comprising:
a substrate including an active pattern;
a channel pattern on the active pattern, the channel pattern comprising a plurality of semiconductor patterns that are spaced apart from each other;
a source/drain pattern electrically connected to the plurality of semiconductor patterns;
an inner gate electrode between adjacent first and second semiconductor patterns of the plurality of semiconductor patterns;
an inner gate insulating layer between the inner gate electrode and the first and second semiconductor patterns;
an inner high-k dielectric layer between the inner gate electrode and the inner gate insulating layer; and
an inner spacer between the inner gate insulating layer and the source/drain pattern,
wherein the inner gate insulating layer comprises:
an upper insulating layer between the inner gate electrode and the second semiconductor pattern;
a lower insulating layer between the inner gate electrode and the first semiconductor pattern; and
an inner gate spacer between the inner gate electrode and the source/drain pattern,
wherein a first thickness of the inner gate spacer at a center portion of the inner gate spacer is greater than a second thickness of the upper insulating layer or the lower insulating layer, and
wherein a third thickness of the inner spacer is greater than the first thickness of the inner gate spacer.

2. The semiconductor device of claim 1, wherein the first thickness ranges from 1.0Å to 15.0Å.

3. The semiconductor device of claim 1, wherein the second thickness ranges from 1.0Å to 10.0Å.

4. The semiconductor device of claim 1, wherein the third thickness ranges from 10.0Å to 25.0Å.

5. The semiconductor device of claim 1, wherein each of the inner gate spacer and the inner spacer includes SiOₓ, SiₓN_{y}, SiₓO_{y}C_{z}Nᵥ, or a combination thereof, and
wherein the inner gate spacer and the inner spacer include different insulating materials.

6. The semiconductor device of claim 1, wherein the inner spacer comprises:
a first sidewall in contact with the source/drain pattern; and
a second sidewall in contact with the inner gate spacer,
wherein each of the first and second sidewalls has a curved surface.

7. The semiconductor device of claim 6, wherein a curvature of the first sidewall is less than a curvature of the second sidewall.

8. The semiconductor device of claim 6, wherein the inner high-k dielectric layer comprises:
a third sidewall in contact with the inner gate electrode; and
a fourth sidewall in contact with the inner gate spacer, and
wherein each of the third and fourth sidewalls has a flat surface in a direction perpendicular to a surface of the substrate.

9. The semiconductor device of claim 1, wherein the inner gate spacer comprises:
a vertical portion having a first length in a first direction;
a first corner portion on the vertical portion and having a second length in the first direction; and
a second corner portion under the vertical portion and having a third length in the first direction,
wherein the first thickness is an average value of the first, second, and third lengths.

10. A semiconductor device comprising:
a substrate including a first active pattern and a second active pattern;
a first channel pattern and a second channel pattern on the first active pattern and the second active pattern, respectively, wherein the first and second channel patterns each comprises a plurality of semiconductor patterns that are spaced apart from each other;
a first source/drain pattern electrically connected to the first channel pattern;
a second source/drain pattern electrically connected to the second channel pattern;
a first inner gate electrode between adjacent semiconductor patterns of the plurality of semiconductor patterns of the first channel pattern;
a second inner gate electrode between adjacent semiconductor patterns of the plurality of semiconductor patterns of the second channel pattern;
a first inner gate insulating layer between the first inner gate electrode and the adjacent semiconductor patterns of the first channel pattern;
a second inner gate insulating layer between the second inner gate electrode and the adjacent semiconductor patterns of the second channel pattern;
a first inner high-k dielectric layer between the first inner gate electrode and the first inner gate insulating layer; and
a second inner high-k dielectric layer between the second inner gate electrode and the second inner gate insulating layer,
wherein the first inner gate insulating layer comprises:
a first upper insulating layer on a top surface of the first inner gate electrode;
a first lower insulating layer on a bottom surface of the first inner gate electrode; and
a first inner gate spacer on both sidewalls of the first inner gate electrode,
wherein the second inner gate insulating layer comprises:
a second upper insulating layer on a top surface of the second inner gate electrode;
a second lower insulating layer on a bottom surface of the second inner gate electrode; and
a second inner gate spacer on both sidewalls of the second inner gate electrode,
wherein the semiconductor device further comprises:
an inner spacer between the first inner gate spacer and the first source/drain pattern,
wherein a thickness of the second inner gate spacer is less than a sum of a thickness of the first inner gate spacer and a thickness of the inner spacer.

11. The semiconductor device of claim 10, wherein the first inner gate spacer is spaced apart from the first source/drain pattern, and
wherein the second inner gate spacer is in contact with the second source/drain pattern.

12. The semiconductor device of claim 10, further comprising:
an air gap between the first inner gate spacer and the inner spacer.

13. The semiconductor device of claim 10, wherein each of the first and second inner gate spacers and the inner spacer includes SiOₓ, SiₓN_{y}, SiₓO_{y}C_{z}Nᵥ, or a combination thereof, and
wherein the first inner gate spacer and the inner spacer include different insulating materials.

14. A semiconductor device comprising:
a substrate including an active pattern;
a channel pattern on the active pattern, the channel pattern comprising a plurality of semiconductor patterns that are spaced apart from each other;
a source/drain pattern electrically connected to the plurality of semiconductor patterns;
a gate electrode on the plurality of semiconductor patterns, wherein the gate electrode comprises:
an inner gate electrode between adjacent ones of the plurality of semiconductor patterns; and
an outer gate electrode on an uppermost semiconductor pattern of the plurality of semiconductor patterns;
a gate insulating layer between the gate electrode and the plurality of semiconductor patterns, wherein the gate insulating layer comprises:
an inner gate insulating layer between the inner gate electrode and the plurality of semiconductor patterns; and
an outer gate insulating layer on the uppermost semiconductor pattern;
a high-k dielectric layer between the gate electrode and the gate insulating layer; and
an inner spacer between the inner gate insulating layer and the source/drain pattern,
wherein the inner gate insulating layer comprises:
an upper insulating layer on a top surface of the inner gate electrode;
a lower insulating layer on a bottom surface of the inner gate electrode; and
an inner gate spacer between the inner gate electrode and the inner spacer,
wherein each of the upper insulating layer and the lower insulating layer comprises:
body portions parallel to a top surface or bottom surface of the inner gate electrode; and
tail portions on sides of the body portions,
wherein the body portion has a first length in a vertical direction that is perpendicular to the substrate,
wherein the tail portion has a second length in the vertical direction, and
wherein a variation of the second length over a predetermined horizontal distance is greater than a variation of the first length over the predetermined horizontal distance.

15. The semiconductor device of claim 14, wherein the first length has a substantially uniform value.
